# EUROPEAN PATENT SPECIFICATION

(11) **EP 2 818 930 B1**
(45) Date of publication and mention of the grant of the patent: **22.08.2018**
(21) Application number: 13751553.2
(22) Date of filing: 30.01.2013
(51) Int. Cl.: G03F 7/30, G03F 7/027, G03F 7/32

(54) **METHOD OF CONCENTRATING PLATE-MAKING PROCESS WASTE LIQUID, AND METHOD OF RECYCLING PLATE-MAKING PROCESS WASTE LIQUID**
VERFAHREN ZUR KONZENTRIERUNG DES FLÜSSIGEN ABFALLS AUS DER DRUCKPLATTENHERSTELLUNG, SOWIE VERFAHREN ZUR WIEDERAUFBEREITUNG DES FLÜSSIGEN ABFALLS AUS DER DRUCKPLATTENHERSTELLUNG
PROCÉDÉ DE CONCENTRATION DE LIQUIDE DE DÉCHETS DE FABRICATION DES PLAQUES D'IMPRESSION ET PROCÉDÉ DE RECYCLAGE DE LIQUIDE DE DÉCHETS DE FABRICATION DES PLAQUES D'IMPRESSION

(30) Priority: 20.02.2012 JP 2012034569
(43) Date of publication of application: 31.12.2014
(73) Proprietor: FUJIFILM Corporation, Tokyo 106-8620 (JP)
(72) Inventor: IMAIZUMI, Mitsuhiro, Haibara-gun, Shizuoka 421-0396 (JP); WATANABE, Toshihiro, Haibara-gun, Shizuoka 421-0396 (JP)
(74) Representative: Hoffmann Eitle
(86) International application number: PCT/JP2013/052106
(87) International publication number: WO 2013/125315

(56) References cited:
- EP-A1- 1 406 125
- EP-A1- 2 163 949
- EP-A1- 2 757 417
- EP-A1- 2 762 977
- JP-A- H01 304 462
- JP-A- 2004 070 031
- JP-A- 2005 010 264
- JP-A- 2006 309 160
- JP-A- 2008 080 229
- JP-A- 2011 090 282

## Description

### TECHNICAL FIELD

The present invention relates to a concentrating method and a recycling method of plate-making process waste liquid that is generated, when a photosensitive planographic printing plate precursor is subjected to a plate-making process using an automatic developing machine, by performing a development process and a desensitization process simultaneously in a development processing bath.

### BACKGROUND ART

When a photosensitive planographic printing plate precursor is subjected to a development process using an automatic developing machine, in order to maintain the concentration of a component that is lost through the process or over time, or the pH, at a constant level, and to retain the performance of a developer liquid, a means for supplying a developer replenishing liquid to the developer liquid of various steps has been conventionally employed. When the performance of the developer liquid is outside the permissible limit even if such replenishment is carried out, all of the developer liquid is discarded. Since plate-making process waste liquid is strongly alkaline, the waste liquid cannot be discharged directly as common drainage, and the plate-making business operator needs to carry out waste liquid processing by installing a waste liquid processing facility, or by outsourcing the process to a waste liquid processing business operator.

However, the method of outsourcing the process to a waste liquid processing business operator requires a huge space for the storage of waste liquid, and also requires very high costs. Furthermore, there is a problem in that the waste liquid processing facility requires a very high initial investment, and a considerably extensive space is required for the equipment of the facility.

In regard to such a problem, there has been suggested a technology of lowering the pH of the developer liquid, performing a desensitization process simultaneously with a development process, and reducing the discharged waste liquid (see, for example, Japanese Patent Application Laid-Open (JP-A) No. 2008-233660).

Furthermore, there have been suggested a method of blowing hot air to a waste liquid storage tank, and concentrating waste liquid (see, for example, JP-ANo. H05-341535); and a method of neutralizing waste liquid to be processed, and flocculating flocculable components by adding a flocculant to the waste liquid (see, for example, JP-ANo. H02-157084).

Also suggested is a planographic printing plate-making process waste liquid reducing apparatus which can reduce the amount of discharge of plate-making process waste liquid, and can easily reutilize the water produced during the course of processing plate-making process waste liquid (see, for example, Japanese Patent No. 4774124).

On the other hand, in regard to the problem of waste liquid from a development process of a planographic printing plate, it has been suggested to use a developer liquid containing a non-reducing sugar and a base, from the viewpoint of the developer liquid formulation for a planographic printing plate (see, for example, JP-ANo. 2011-90282). However, it cannot be expected in the current situation to attain a satisfactory solution of the problems related to waste liquid processing, only by changing the formulation of the developer liquid.

EP 2 757 417 A1 (prior art pursuant to Art. 54(3) EPC) describes a method for recycling waste water produced by plate-making process. Example 1 thereof refers to a negative-type printing plate. It describes the use of developer liquid including 25% of a surfactant and 1% of potassium hydroxide. According to claim 14 the developer liquid has a pH of 10 to 12.5. It is said that the developer liquid does not include a silicate compound.

EP 2 762 977 A1 (prior art pursuant to Art. 54(3) EPC) is directed to a method for recycling plate-making processing waste solution. The developer liquid has a pH from 10 to 13 or 10 to 12.5. Such a liquid comprises a surfactant and an alkali metal hydroxide and does not include a silicate compound.

EP 2 163 949 A1 describes a developer for lithographic printing plate precursor and a process for producing lithographic printing plate.

JP 2004-070031 describes a method of treating a developer waste liquid produced in the processes of exposing a water developable photosensitive resin plate and then removing the unexposed part with at least water and a developer containing water and a surfactant. The water is vaporized under the conditions of ≤ 2 atm to separate concentrated liquid containing the resin in the unexposed part from a condensed liquid essentially comprising water.

JP 2011-090282 relates to a waste liquid concentrating method. This document describes a positive plate planographic printing plate precursor.

### SUMMARY OF INVENTION

### TECHNICAL PROBLEM

In the technology of concentrating waste liquid using hot air, since the amount of evaporation is not much, the effect of reducing the amount of waste liquid is not sufficient, and there is a problem in that a long time is required to sufficiently concentrate plate-making process waste liquid. Furthermore, no investigation has been made on the processing of evaporated moisture.

The technology of using a flocculant has a problem in that processing of waste liquid requires large expenses, and in a case in which the plate-making process waste liquid contains polymer compounds, there is a problem in that maintenance is complicated, as the solids remaining in the evaporating pot become viscous and adhere to the wall surfaces of the evaporating pot, the evaporating pot is susceptible to contamination, and the piping of the waste liquid processing apparatus is prone to be clogged.

The invention has been achieved in consideration of the problems described above, and it is an object of the invention to provide a method of concentrating plate-making process waste liquid, in which, at the time of concentrating waste liquid generated during a plate-making process of simultaneously performing a development process and a desensitization process using a developer liquid in a development processing bath of an automatic developing machine, foaming of the waste liquid is suppressed, and the waste liquid is concentrated efficiently, and washing of the concentrating pot or the like can be easily carried out.

It is another object of the invention to provide a method of recycling plate-making process waste liquid, in which, by reutilizing the reclaimed water obtained when plate-making process waste liquid is concentrated, contamination caused by accumulation of deposits in a developing bath of an automatic developing machine is reduced, and even in a case in which a plate-making process is carried out continuously for a long time, generation of precipitates is suppressed.

### SOLUTION TO PROBLEM

As a result of earnest study to solve the above-described problems, it has been found that the above-described problems can be solved by using a developer liquid containing a specific surfactant when simultaneously performing development and desensitization in a developing bath, and the invention has been completed. That is, the configuration of the invention is as shown below.
[1] A method of concentrating waste liquid from a plate-making process of a planographic printing plate, the method comprising:
   a plate-making processing step of subjecting a negative-type photosensitive planographic printing plate precursor, having a radical polymerizable image recording layer on a support, after exposure simultaneously to a development process and a desensitization process using a developer liquid in a single development processing bath of an automatic developing machine that develops the photosensitive planographic printing plate precursor after exposure, wherein the developer liquid contains from 1% by mass to 10% by mass, based on the total amount of developer liquid, of a surfactant having a phenyl group or a naphthyl group and at least either an ethylene oxide group or a propylene oxide group, has a content of an organic solvent having a boiling point in a range of from 100°C to 300°C of 2% by mass or less, based on the total amount of the developer liquid, and substantially does not contain an organic solvent having a boiling point lower than 100°C or higher than 300°C;
   a waste liquid concentrating step of evaporatively concentrating plate-making process waste liquid produced by the plate-making processing step using a waste liquid concentrating apparatus such that a ratio of a volume of the plate-making process waste liquid after concentration to a volume of the plate-making process waste liquid before concentration is from 1/2 to 1/10; and
   a reclaimed water producing step of producing reclaimed water by condensing water vapor separated in the waste liquid concentrating step,
   wherein a pH of the developer liquid is from 6 to 10, wherein a developer liquid is excluded which includes a surfactant and a hydroxide of an alkali metal but does not include a silicate compound, and which has a pH of 10.
[2] A method of recycling waste liquid from a plate-making process of a planographic printing plate according to [1], the method comprising after the steps of [1] above: a reclaimed water producing step of producing reclaimed water by condensing water vapor separated in the waste liquid concentrating step; and
   a reclaimed water supplying step of supplying the reclaimed water obtained in the reclaimed water producing step to the automatic developing machine.
[3] The method of recycling plate-making process waste liquid according to [2], wherein the surfactant has from 5 to 30 of the at least one of an ethylene oxide group or a propylene oxide group.
[4] The method of recycling plate-making process waste liquid according to [2] or [3], wherein the developer liquid further contains at least one compound represented by the following Formula <1>, Formula <2>, or Formula <3>, and a total content of the compounds represented by the following Formula <1>, Formula <2>, and Formula <3> in the developer liquid is less than 10% by mass: 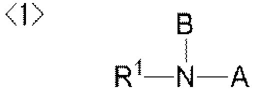 wherein, in Formula <1>, R¹ represents a hydrogen atom, an alkyl group, or a substituent having the following structure: 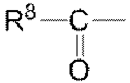 wherein R⁸ represents a hydrogen atom or an alkyl group; and
   A represents a hydrogen atom, an alkyl group, a monovalent substituent containing an ethylene oxide group, a monovalent substituent containing a carboxylic acid group, or a monovalent substituent containing a carboxylic acid salt; and B represents a monovalent substituent containing an ethylene oxide group, a monovalent substituent containing a carboxylic acid group, or a monovalent substituent containing a carboxylic acid salt; 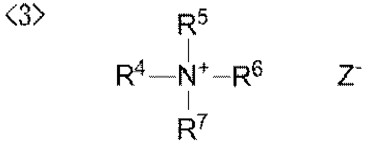 wherein, in Formula <3>, each of R⁴, R⁵, R⁶, and R⁷ independently represents a hydrogen atom or an alkyl group; and Z⁻ represents a counter anion.
[5] The method of recycling plate-making process waste liquid according to any one of [2] to [4], wherein a pH of the developer liquid is from 6 to 10.
[6] The method of recycling plate-making process waste liquid according to any one of [2] to [5], further comprising drying a planographic printing plate obtained by subjecting the photosensitive planographic printing plate precursor after exposure to the development process and the desensitization process.
[7] The method of recycling plate-making process waste liquid according to any one of [2] to [5], further comprising: heating the photosensitive planographic printing plate precursor after exposure, before performing the development process and the desensitization process; and drying a planographic printing plate obtained by subjecting the photosensitive planographic printing plate precursor after exposure to the development process and the desensitization process.
[8] The method of recycling plate-making process waste liquid according to any one of [2] to [7], wherein the waste liquid concentrating apparatus includes a heating means.
[9] The method of recycling plate-making process waste liquid according to [8], wherein heating is carried out by the heating means included in the waste liquid concentrating apparatus under reduced pressure.
[10] The method of recycling plate-making process waste liquid according to [8] or [9], wherein the heating means included in the waste liquid concentrating apparatus is a heat pump including a heat releasing unit and a heat absorbing unit, and the plate-making process waste liquid is heated by the heat releasing unit of the heat pump, while the water vapor is cooled by the heat absorbing unit of the heat pump.
[11] The method of recycling plate-making process waste liquid according to any one of [2] to [10], wherein the waste liquid concentrating step comprises a concentrate collecting step of collecting a concentrate of the plate-making process waste liquid, which has been concentrated by evaporative concentration, into a collecting tank by applying pressure to the concentrate using a pump.

### ADVANTAGEOUS EFFECTS OF INVENTION

According to the invention, the amount of waste liquid can be reduced by simultaneously performing a development process and a desensitization process using a developer liquid in a development processing bath of an automatic developing machine, and the invention can further reduce the amount of waste liquid to be discarded to a large extent, by concentrating the plate-making process waste liquid. Furthermore, foaming is suppressed at the time of concentrating the plate-making process waste liquid, and washing of the concentrating apparatus can be carried out easily. There is no problem of the plate-making process waste liquid being mixed into the reclaimed water, a large increase in the viscosity during the concentrating operation, or solids precipitating out, and since reclaimed water is recycled into the developing bath, even in a case in which a plate-making process is carried out continuously for a long time, the waste liquid to be discarded as plate-making process waste liquid can be reduced to a large extent.

### BRIEF DESCRIPTION OF DRAWINGS

Fig. 1 is a conceptual diagram illustrating the flow of an apparatus related to the method of recycling plate-making process waste liquid of the invention.

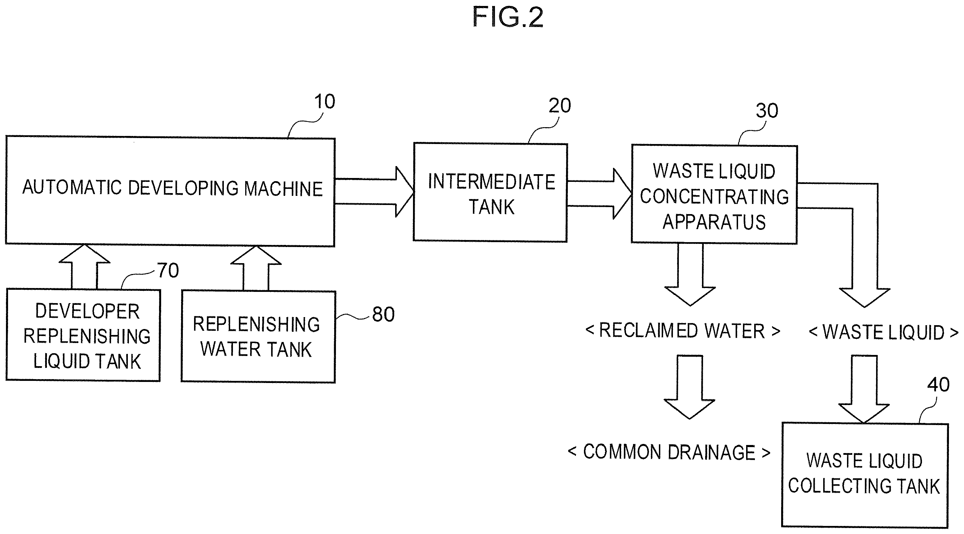

Fig. 2 is a conceptual diagram illustrating the flow of a conventional development processing apparatus having an apparatus for concentrating development process waste liquid.
Fig. 3 is a diagram of an automatic developing apparatus which simultaneously performs a development process and gumming in a developing bath.

### DESCRIPTION OF EMBODIMENTS

Hereinafter, the invention will be explained in detail.

### [Method of Concentrating Waste Liquid from Plate-Making Process for Photosensitive Planographic Printing Plate Precursor (hereinafter, referred to as a waste liquid concentrating method in some cases)]

A waste liquid concentrating method of the invention comprises:
a plate-making processing step of subjecting a photosensitive planographic printing plate precursor, having a radical polymerizable image recording layer on a support, after exposure simultaneously to a development process and a desensitization process using a developer liquid in a single development processing bath of an automatic developing machine that develops the photosensitive planographic printing plate precursor after exposure, wherein the developer liquid contains from 1% by mass to 10% by mass of a surfactant having a phenyl group or a naphthyl group and at least either an ethylene oxide group or a propylene oxide group, has a content of an organic solvent having a boiling point in a range of from 100°C to 300°C of 2% by mass or less, and substantially does not contain an organic solvent having a boiling point lower than 100°C or higher than 300°C;
a waste liquid concentrating step of evaporatively concentrating plate-making process waste liquid produced by the plate-making processing step using a waste liquid concentrating apparatus such that a ratio of a volume of the plate-making process waste liquid after concentration to a volume of the plate-making process waste liquid before concentration is from 1/2 to 1/10; and
a reclaimed water producing step of producing reclaimed water by condensing water vapor separated in the waste liquid concentrating step.

In a photosensitive planographic printing plate precursor, an image forming layer on a support is exposed to form a latent image, subsequently non-image areas are removed by development, and thus a planographic printing plate is produced. The photosensitive planographic printing plate precursor used in the invention is a negative type photosensitive planographic printing plate precursor having a radical polymerizable image recording layer, and when exposed regions are cured by polymerization and unexposed areas (non-image areas) are removed by development, ink-receiving image area regions are formed. In the method of the invention, one of the features lies in that removal of non-image areas and a desensitization process of formed image areas are carried out in a single developing bath of an automatic developing machine, and through this step, the amount of waste liquid is further reduced as compared with the conventional methods.

Hereinafter, the procedure of the waste liquid concentrating method of the invention will be explained. The photosensitive planographic printing plate precursor used, and the exposure step that precedes the development step will be described later.

### [Plate-Making Processing Step]

In the plate-making processing step, a photosensitive planographic printing plate precursor having a radical polymerizable image recording layer on a support after exposure is subjected simultaneously to a development process and a desensitization process using a developer liquid in a single development processing bath of an automatic developing machine that develops the photosensitive planographic printing plate precursor after exposure, wherein the developer liquid contains from 1% by mass to 10% by mass of a surfactant having a phenyl group or a naphthyl group and at least either an ethylene oxide group or a propylene oxide group, has a content of an organic solvent having a boiling point in a range of from 100°C to 300°C of 2% by mass or less, and substantially does not contain an organic solvent having a boiling point lower than 100°C or higher than 300°C.

### [Developer Liquid]

In regard to the concentrating method and recycling method of plate-making process waste liquid of the invention, the developer liquid that is used for the development of a photosensitive planographic printing plate precursor will be explained.

In the present specification, unless particularly stated otherwise, a developer liquid is used to mean to encompass a development initiating liquid (developer liquid in a narrow sense) and a developer replenishing liquid.

The developer liquid and the developer replenishing liquid, to which the invention is applied, are a developer liquid for developing a photosensitive planographic printing plate precursor having a radical polymerizable image recording layer, the developer liquid being used to perform a development process and a desensitization process simultaneously in a single development processing bath of an automatic developing machine.

The developer liquid of the invention is characterized in that the developer liquid contains from 1% by mass to 10% by mass of a surfactant having either a phenyl group or a naphthyl group, and at least either an ethylene oxide group or a propylene oxide group [hereinafter, appropriately referred to as particular surfactant], has a content of an organic solvent having a boiling point in a range of from 100°C to 300°C of 2% by mass or less, and substantially does not contain an organic solvent having a boiling point lower than 100°C or higher than 300°C. Regarding the content of the organic solvent having a boiling point in the range of from 100°C to 300°C in the developer liquid of the present embodiment, a smaller content is preferred, and according to a preferred aspect, the developer liquid does not contain such an organic solvent. The phrase "substantially does not contain an organic solvent having a boiling point lower than 100°C or higher than 300°C" means that the content of an organic solvent having a boiling point lower than 100°C or higher than 300°C is less than 0.2% by mass. It is preferable that the developer liquid according to the invention does not contain an organic solvent having a boiling point lower than 100°C or higher than 300°C.

The developer liquid used in the development of a photosensitive planographic printing plate precursor of the invention contains a particular surfactant that will be described below in detail. Also, from the viewpoint that a development process and a desensitization process can be favorably carried out in a single bath, the pH of the developer liquid is from 6.0 to 10.0, and a preferred pH is in the range of from 8.0 to 10.0.

### (Particular Surfactant)

The surfactant used in the developer liquid in connection with the waste liquid concentrating method of the invention is not particularly limited as long as the surfactant is a surfactant having either a phenyl group or a naphthyl group and at least either an ethylene oxide group or a propylene oxide group in the molecule.

The ethylene oxide group according to the present specification refers to a structure represented by the following Formula (a), and a propylene oxide group refers to a structure represented by the following Formula (b). Having a plurality of these groups means that a plurality of these groups are connected in a straight chain and forms a polyethylene oxide skeleton or a polypropylene oxide skeleton.

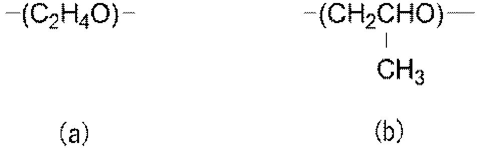

The surfactant included in the developer liquid is preferably an anionic surfactant or a nonionic surfactant. When an anionic surfactant or a nonionic surfactant is used, a wide surfactant concentration latitude can be maintained, and a balance between the liquid penetrability of unexposed areas and the dispersibility of various compounds in the liquid can be achieved.

### [Anionic surfactant]

Examples of an anionic surfactant that is optimally used in the developer liquid include compounds represented by the following Formula (I-A) and Formula (I-B).

A preferred developer liquid is a developer liquid for photosensitive planographic printing plate precursor, containing at least one anionic surfactant selected from the group consisting of an anionic surfactant represented by the following Formula (I-A) and an anionic surfactant represented by the following Formula (I-B), at a content in the range of from 1.0% by mass to 10% by mass. 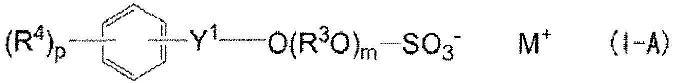 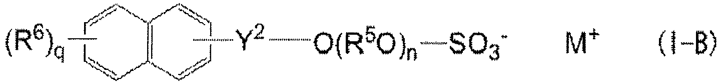 wherein in Formula (I-A) and Formula (I-B), each of R³ and R⁵ independently represents a linear or branched alkylene group having from 1 to 5 carbon atoms, the group containing at least one ethylene group or propylene group; each of R⁴ and R⁶ independently represents a linear or branched alkyl group having from 1 to 20 carbon atoms; each of p and q independently represents 0, 1 or 2; each of Y¹ and Y² independently represents a single bond, or an alkylene group having from 1 to 10 carbon atoms; each of n and m independently represents an integer from 1 to 100, and when each of n and m represents any number from 2 to 100, plural R³s and plural R⁵s may be identical with or different from each other; and M⁺ represents Na⁺, K⁺, Li⁺ or NH₄⁺.

According to a preferred embodiment of the invention, in the above Formulas (I-A) and (I-B), respective preferred examples of R³ and R⁵ include -CH₂-, -CH₂CH₂-, and -CH₂CH(CH₃)-, and at least one represents -CH₂CH₂- or -CH₂CH(CH₃)-. Each of R³ and R⁵ is more preferably -CH₂CH₂-. Furthermore, preferred examples of R⁴ and R⁶ include CH₃, C₂H₅, C₃H₇, and C₄H₉. Each of p and q is preferably 0 or 1. Each of Y¹ and Y² is preferably a single bond. Each of n and m is preferably an integer from 3 to 50, and more preferably an integer from 5 to 30.

Specific examples of the compound represented by Formula (I-A) or Formula (I-B) include the following compounds.

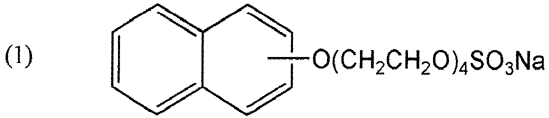

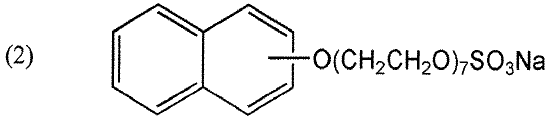

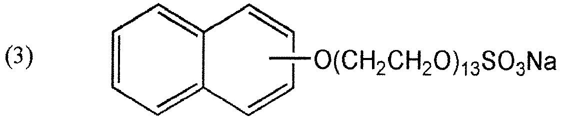

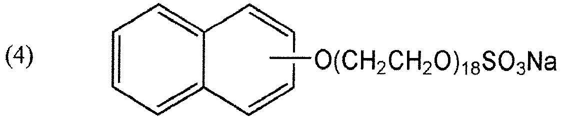

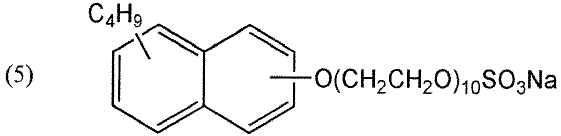

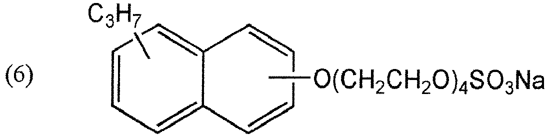

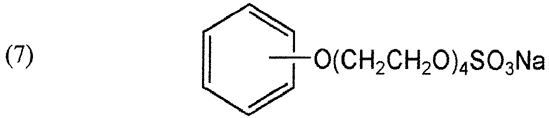

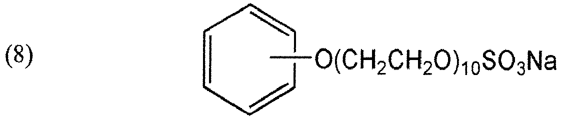

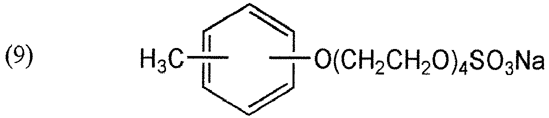

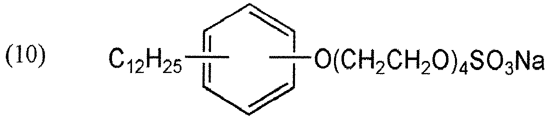

### [Nonionic Surfactant]

Other preferred examples of the particular surfactant according to the invention include a nonionic surfactant represented by the following Formula (II-A) and a nonionic surfactant represented by the following Formula (II-B). 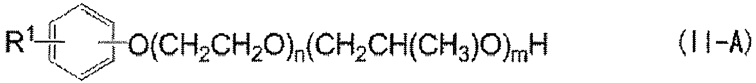 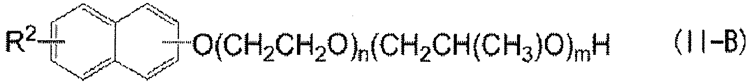 wherein in Formula (II-A) and Formula (II-B), each of R¹ and R² independently represents a hydrogen atom or an alkyl group having from 1 to 100 carbon atoms; and each of n and m independently represents an integer from 0 to 100, provided that n and m are not simultaneously 0.

Specific examples of the compound represented by Formula (II-A) include polyoxyethylene phenyl ether, polyoxyethylene methyl phenyl ether, polyoxyethylene octyl phenyl ether, and polyoxyethylene nonyl phenyl ether.

Specific examples of the compound represented by Formula (II-B) include polyoxyethylene naphthyl ether, polyoxyethylene methyl naphthyl ether, polyoxyethylene octyl naphthyl ether, and polyoxyethylene nonyl naphthyl ether.

In regard to the compounds represented by Formula (II-A) and Formula (II-B), the number of repeating units (n) of the polyoxyethylene group is preferably from 3 to 50, and more preferably from 5 to 30. The number of repeating units (m) of the polyoxypropylene group is preferably from 0 to 10, and more preferably from 0 to 5. When a chain-like polyalkyleneoxy group is formed by linking plural oxyethylene groups and plural oxypropylene groups, the bonding between an oxyethylene group and an oxypropylene group may be random bonding or block bonding. In the above Formula (II-A) and Formula (II-B), when each of n and m is 1 or more, that is, when the nonionic surfactant has oxyethylene groups and oxypropylene groups, the sum of the ethylene oxide groups and the propylene oxide groups is preferably from 5 to 30.

When nonionic aromatic ether-based surfactants represented by Formula (II-A) and Formula (II-B) are used, the surfactants may be used singly, or two or more kinds thereof may be used in combination in the developer liquid.

Specific examples of the compound represented by the following Formula (II-A) or Formula (II-B) will be described below, but the invention is not intended to be limited to these.

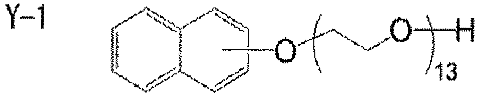

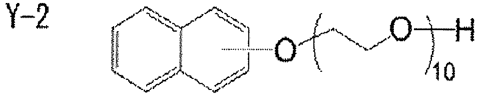

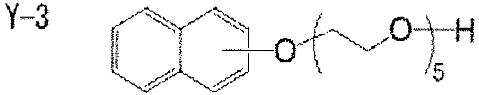

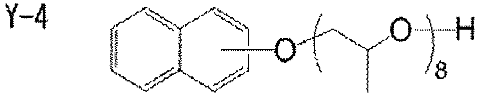

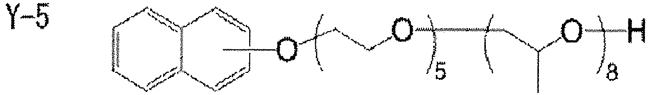

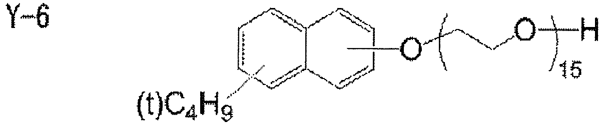

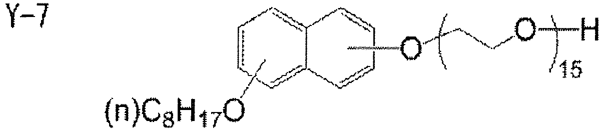

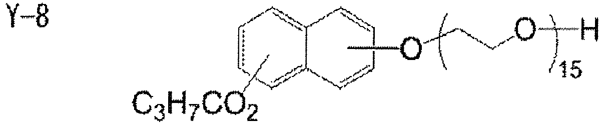

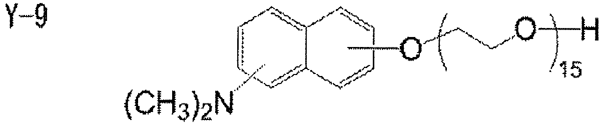

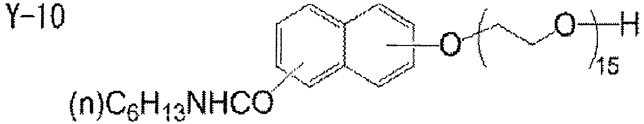

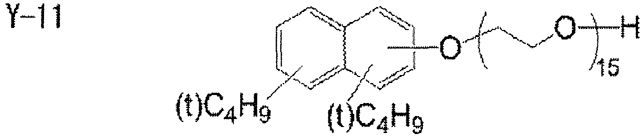

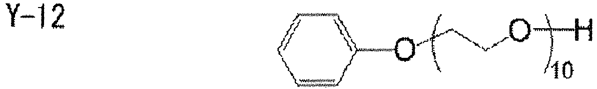

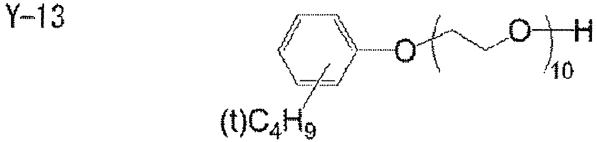

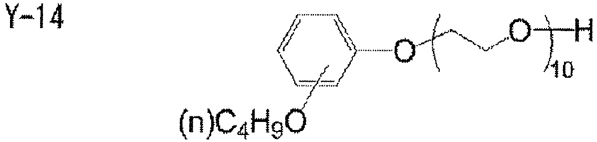

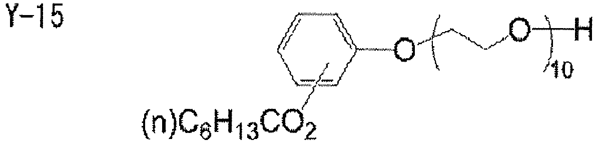

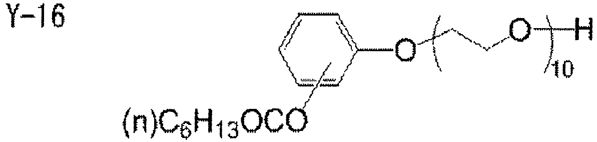

The particular surfactants described above can be used singly or in combination of plural kinds thereof. When two or more kinds are used in combination, any of an aspect including two or more kinds of the particular anionic surfactants only, an aspect including two or more kinds of the particular nonionic surfactants, and an aspect including one or more kinds of each of the particular anionic surfactant and the particular nonionic surfactant, may be used.

The amount of addition of the particular surfactant needs to be in the range of from 1% by mass to 10% by mass in the developer liquid, and the amount of addition is preferably in the range of from 2% by mass to 10% by mass, and more preferably in the range of from 3% by mass to 10% by mass, from the viewpoint of the effect. When the amount of addition of the particular surfactant in the developer liquid is adjusted to 1% by mass or more, favorable developability and favorable solubility of the image recording layer components in the developer liquid are obtained, and when the amount of addition is adjusted to 10% by mass or less, printing durability of the planographic printing plate thus formed becomes favorable.

When two or more kinds of the particular surfactants are included, the amount of addition represents the total amount.

### (Another Surfactant)

The developer liquid used in the invention may include, in addition to the particular surfactant described above, another surfactant (a surfactant having a structure different from that of the particular surfactant, for example, a surfactant which does not contain any of a phenyl group or a naphthyl group, and an ethylene oxide group or a propylene oxide group) to the extent that the effects of the invention are not impaired.

Examples of the other surfactant that can be additionally used include betaine-type surfactants represented by the following Formula <1>, Formula <2>, or Formula <3>:

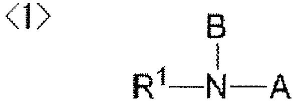

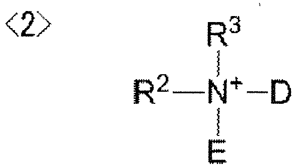

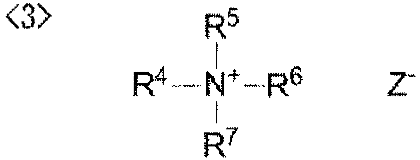

In Formula <1>, R¹ represents a hydrogen atom, an alkyl group, or a substituent having the structure described below; A represents a hydrogen atom, an alkyl group, a monovalent substituent containing an ethylene oxide group, a monovalent substituent containing a carboxylic acid group, or a monovalent substituent containing a carboxylic acid salt; B represents a monovalent substituent containing an ethylene oxide group, a monovalent substituent containing a carboxylic acid group, or a monovalent substituent containing a carboxylic acid salt. 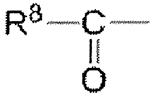 wherein R⁸ represents a hydrogen atom or an alkyl group.

In the above Formula <2>, each of R² and R³ independently represents a hydrogen atom, or an alkyl group which may have a substituent, and at least one of R² or R³ represents an alkyl group which may have a substituent.

D represents an alkyl group or a monovalent substituent containing an ethylene oxide group, and E represents a monovalent substituent containing a carboxylate anion, or a monovalent substituent containing an oxide anion (O⁻).

In the above Formula <3>, each of R⁴, R⁵, R⁶, and R⁷ independently represents a hydrogen atom or an alkyl group, and Z⁻ represents a counter anion.

In the above Formula <1> and Formula <2>, the ethylene oxide group contained in the monovalent substituent containing an ethylene oxide group means -(CH₂CH₂O)ₙH (wherein n represents an integer of 1 or larger, and preferably from 2 to 20), and the monovalent substituent containing an ethylene oxide group as used herein is intended to also encompass an ethylene oxide group.

In Formula <1>, the monovalent substituent containing a carboxylic acid group also encompasses the case of a carboxylic acid group only. In Formula <1>, a carboxylic acid salt of a group containing a carboxylic acid salt means -COOM, and M represents an alkali metal or an alkaline earth metal, and is preferably an alkali metal. The monovalent substituent containing a carboxylic acid salt also encompasses the case of a carboxylic acid salt only.

In Formula <2>, the monovalent substituent containing a carboxylate anion also encompasses the case of a carboxylate anion only. In Formula <2>, the monovalent substituent containing an oxide anion (O⁻) also encompasses the case of an oxide anion only.

The compound represented by Formula <1>, Formula <2>, or Formula <3> (hereinafter, also referred to as particular betaine type surfactant) is not particularly limited, but representative examples include compounds represented by the following Formula (I) to Formula (V):

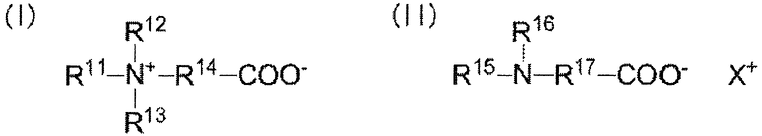

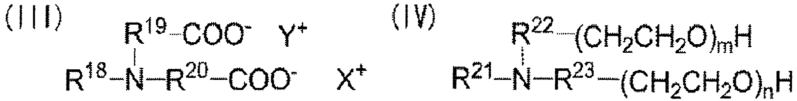

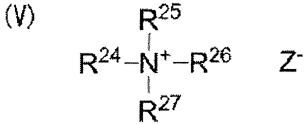

Further, examples of the particular betaine type surfactant also include a surfactant represented by the following Formula (VI):

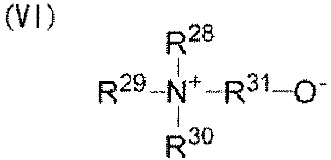

In Formula (I) to Formula (VI), R¹¹ represents a hydrogen atom; an alkyl group; or an alkyl group linked through a bond selected from an ester bond, a carbonyl bond and an amide bond. The number of carbon atoms of the alkyl group linked through the bond described above is preferably from 8 to 20.

Each of R¹², R¹⁵, R¹⁸ and R²⁴ to R²⁹ independently represents a hydrogen atom or an alkyl group.

R¹³ represents an alkyl group or a monovalent substituent containing an ethylene oxide group.

R¹⁶ represents a hydrogen atom, an alkyl group, or a monovalent substituent containing an ethylene oxide group.

R²¹ represents a hydrogen atom, an alkyl group, or a group shown below: 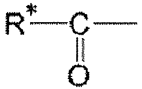 wherein R* represents a hydrogen atom or an alkyl group.

R³⁰ represents an alkyl group, or a group containing an ethylene oxide group.

Each of R¹⁴, R¹⁷, R¹⁹, R²⁰, R²², R²³ and R³¹ independently represents an alkylene group or a single bond.

In the betaine type surfactant included in the above Formula (I), N and the carboxyl group may be directly linked, and in this case, R¹⁴ represents a single bond. In regard to the surfactant represented by Formula (I), when the total number of carbon atoms increases, the hydrophobic moiety becomes larger, and dissolution in a water-based developer liquid is made difficult. In this case, dissolution is ameliorated by mixing an organic solvent which helps dissolution, or a dissolution aid such as an alcohol, into water; however, if the total number of carbon atoms becomes too large, the surfactant cannot be dissolved within an adequate extent of mixing. Here, the sum of the numbers of carbon atoms of R¹¹ to R¹⁴ is preferably from 10 to 40, and more preferably from 12 to 30.

Here, when R¹¹ to R¹³ described above represent alkyl groups, or R¹⁴ represents an alkylene group, the structure may be linear, or may be branched.

The number of carbon atoms of R¹¹ to R¹⁴ in these compounds (particular betaine type surfactants) is affected by the material used in the image recording layer, particularly a binder. In the case of a binder having a higher degree of hydrophilicity, there is a tendency that relatively smaller numbers of carbon atoms of R¹¹ to R¹⁴ are preferable, and when the binder used has a lower degree of hydrophilicity, it is preferable that the numbers of carbon atoms of R¹¹ to R¹⁴ are larger.

Representative examples of the betaine type surfactant represented by Formula (I) include compounds shown below.

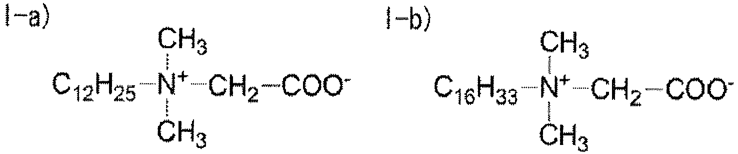

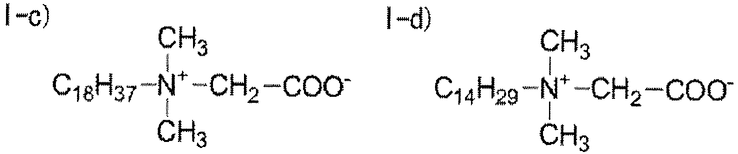

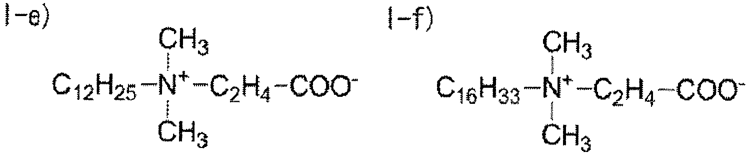

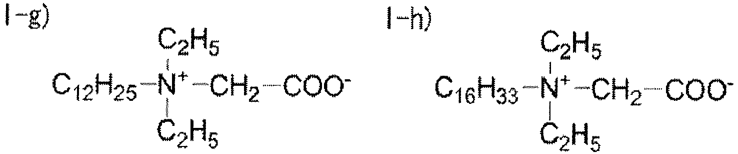

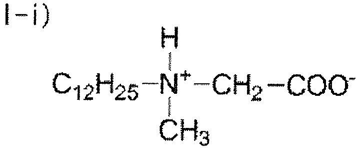

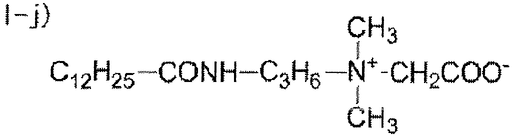

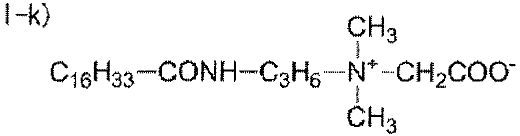

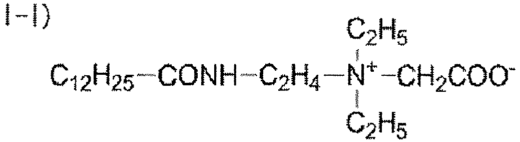

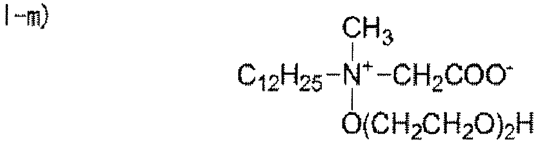

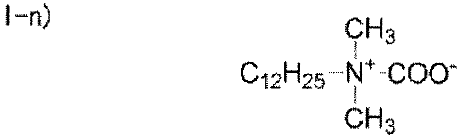

Also, for those other surfactants shown below, when the total number of carbon atoms is increased, the hydrophobic moiety becomes larger, and dissolution into a water-based developer liquid is difficult. Therefore, it is preferable to select the total number of carbon atoms of a surfactant in consideration of the amount of use of the solvent or surfactant used, and the appropriate extent of mixing.

In regard to the betaine type surfactant represented by Formula (II), R¹⁵ in the formula represents a hydrogen atom or an alkyl group; R¹⁶ represents a hydrogen atom, an alkyl group, or a monovalent substituent containing an ethylene oxide group; and R¹⁷ represents an alkylene group or a single bond.

Here, the sum of the number of carbon atoms of R¹⁵ to R¹⁷ is preferably from 10 to 30, and more preferably from 12 to 25.

Here, when R¹⁵ and R¹⁶ are alkyl groups, or R¹⁷ is an alkylene group, the structures thereof may be straight-chained, or may be branched.

The number of carbon atoms of R¹⁵ to R¹⁷ in the betaine type surfactant represented by Formula (II) is appropriately selected in relation to the other materials used in the image recording layer. For example, when a binder having a higher degree of hydrophilicity is used in combination, relatively smaller numbers of carbon atoms of R¹⁵ to R¹⁷ are preferred, and when a binder having a lower degree of hydrophilicity is used in combination, larger numbers of carbon atoms of R¹⁵ to R¹⁷ are preferred.

Furthermore, for X⁺ in the compounds described above, a monovalent metal ion such as a potassium ion or a sodium ion; a divalent metal ion such as a calcium ion or a magnesium ion; an ammonium ion; a hydrogen ion; or the like is used. In the surfactant represented by Formula (II), a sodium ion or a potassium ion is particularly preferred. Representative examples of the surfactant represented by Formula (II) include compounds shown below.

II-a) C₁₂H₂₅-NH-CH₂-COO⁻ Na⁺

II-b) C₁₄H₂₉-NH-CH₂-COO⁻ Na⁺

II-c) C₁₂H₂₅-NH-C₂H₄-COO⁻ Na⁺

II-d) C₁₄H₂₉NH-C₂H₄-COO⁻ Na⁺

II-e) C₁₆H₃₃-NH-CH₂-COO⁻ Na⁺

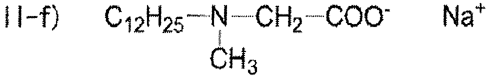

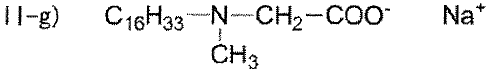

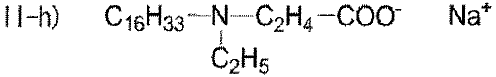

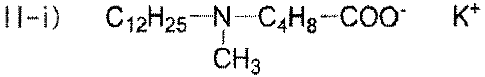

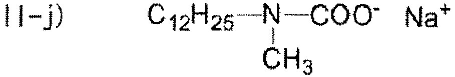

In regard to the betaine type surfactant represented by Formula (III), R¹⁸ represents a hydrogen atom or an alkyl group; and each of R¹⁹ and R²⁰ represents an alkylene group or a single bond.

Here, the sum of the numbers of carbon atoms of R¹⁸ to R²⁰ is preferably from 10 to 30, and more preferably from 12 to 28.

Here, when R¹⁸ is an alkyl group, and R¹⁹ and R²⁰ are alkylene groups, the structures thereof may be straight-chained, or may be branched.

The number of carbon atoms of R¹⁸ to R²⁰ in the betaine type surfactant represented by Formula (III) is appropriately selected in relation to the other materials used in the image recording layer. For example, when a binder having a higher degree of hydrophilicity is used in combination, relatively smaller numbers of carbon atoms of R¹⁸ to R²⁰ are preferred, and when a binder having a lower degree of hydrophilicity is used in combination, larger numbers of carbon atoms of R¹⁸ to R²⁰ are preferred.

Furthermore, for X⁺ and Y⁺ in the compounds described above, a monovalent metal ion such as a potassium ion or a sodium ion; a divalent metal ion such as a calcium ion or a magnesium ion; an ammonium ion; a hydrogen ion; or the like is used. In regard to the compound (III), among these, a sodium ion or a potassium ion is particularly preferred. Representative examples of the compound include compounds shown below.

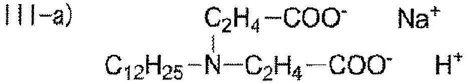

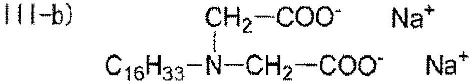

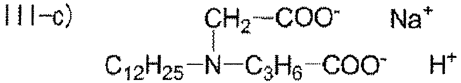

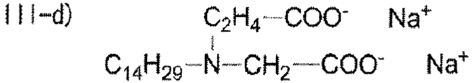

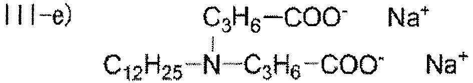

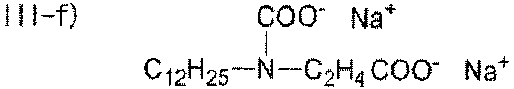

In regard to the betaine type surfactant represented by Formula (IV), N and ethylene oxide may be directly linked, and in this case, R²² and R²³ represent single bonds.

Here, the sum of the numbers of carbon atoms of R²¹ to R²³ is preferably from 8 to 50, and more preferably from 12 to 40.

Here, when R²¹ represents an alkyl group, and R²² and R²³ represent alkylene groups, the structures thereof may be straight-chained, or may be branched.

The numbers of carbon atoms of R²¹ to R²³ in the surfactant represented by Formula (IV) are appropriately selected in relation to the other materials used in the image recording layer. For example, when a binder having a higher degree of hydrophilicity is used in combination, relatively smaller numbers of carbon atoms of R²¹ to R²³ are preferred, and when a binder having a lower degree of hydrophilicity is used in combination, larger numbers of carbon atoms of R²¹ to R²³ are preferred.

In regard to m and n that represent the numbers of ethylene oxide moieties, when these values are larger, the degree of hydrophilicity is increased, and stability in water is increased, m and n may represent the same number, or may represent different numbers. The sum of m and n is preferably from 3 to 40, and more preferably from 5 to 20. Representative examples of the compound include compounds shown below.

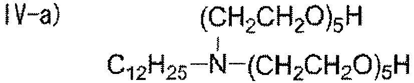

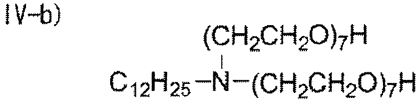

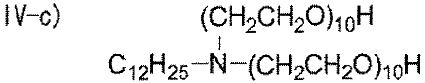

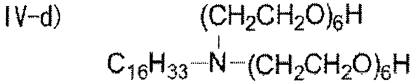

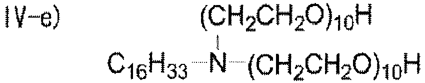

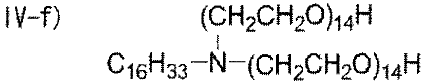

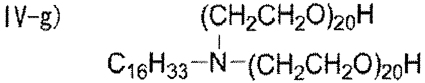

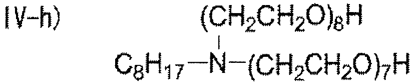

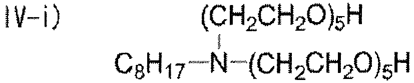

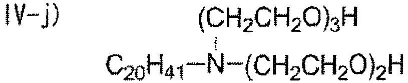

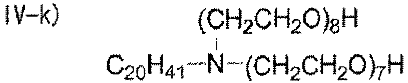

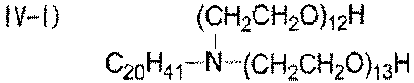

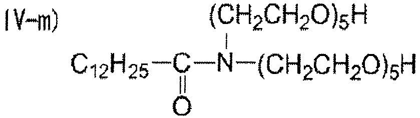

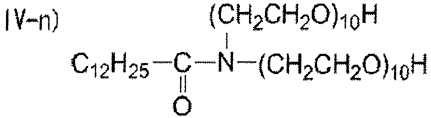

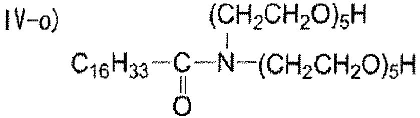

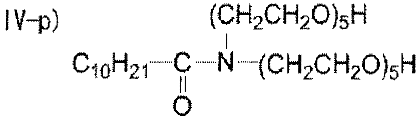

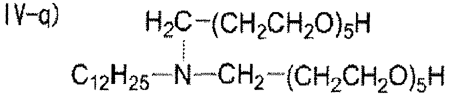

In regard to the betaine type surfactant represented by Formula (V), each of R²⁴ to R²⁷ in the formula represents a hydrogen atom or an alkyl group.

Here, the sum of the numbers of carbon atoms of R²⁴ to R²⁷ is preferably from 10 to 30, and more preferably from 12 to 28.

Here, when R²⁴ to R²⁷ described above are alkyl groups, the structures thereof may be straight-chained, or may be branched.

The numbers of carbon atoms of R²⁴ to R²⁷ in the surfactant represented by Formula (V) are appropriately selected in relation to the other materials used in the image recording layer. For example, when a binder having a higher degree of hydrophilicity is used in combination, relatively smaller numbers of carbon atoms of R²⁴ to R²⁷ are preferred, and when a binder having a lower degree of hydrophilicity is used in combination, larger numbers of carbon atoms of R²⁴ to R²⁷ are preferred.

Furthermore, Z⁻ represents a counter anion. There are no limitations, but in many cases, Cl⁻, Br⁻, I⁻, and the like are used. Representative examples of the compound include compounds shown below.

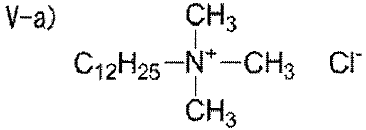

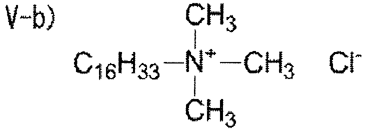

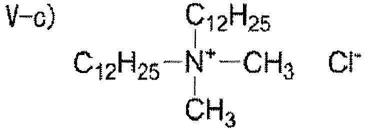

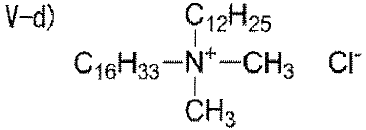

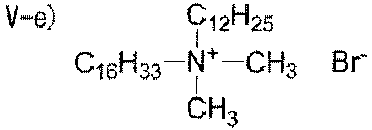

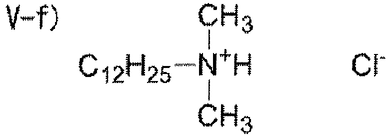

In regard to the compound corresponding to the above Formula (VI), each of R²¹ and R²⁹ in the formula represents a hydrogen atom or an alkyl group; and R³⁰ represents an alkyl group, or a monovalent substituent containing an ethylene oxide group.

Here, the sum of the numbers of carbon atoms of R²⁸ to R³⁰ is preferably from 8 to 30, and more preferably from 10 to 28.

Here, when R²⁸ to R³⁰ are alkyl groups, the structures thereof may be straight-chained, or may be branched.

The numbers of carbon atoms of R²⁸ to R³⁰ in the surfactant represented by Formula (VI) are appropriately selected in relation to the other materials used in the image recording layer. For example, when a binder having a higher degree of hydrophilicity is used in combination, relatively smaller numbers of carbon atoms of R²⁸ to R³⁰ are preferred, and when a binder having a lower degree of hydrophilicity is used in combination, larger numbers of carbon atoms of R²¹ to R³⁰ are preferred.

Representative examples of the compound include compounds shown below.

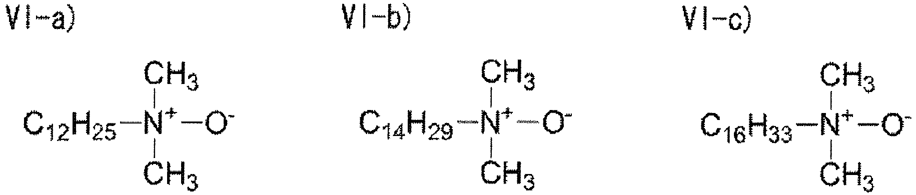

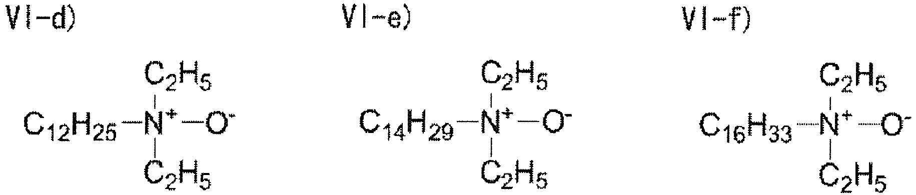

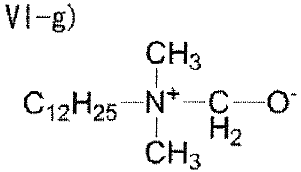

The particular betaine type surfactant, which is the other surfactant, is usually incorporated as desired into the developer liquid used in the invention, but may also be incorporated in order to improve dispersibility of the components of a developed image recording layer, provided that the content thereof is preferably less than 10% by mass with respect to the developer liquid. If the content of the particular betaine type surfactant is 10% by mass or more, there is a possibility that the members in the developing bath are subjected to erosion, which becomes a cause of apparatus failure, and thus such a content is not preferable.

### (Organic Solvent)

According to the invention, the developer liquid/developer replenishing liquid used for the development of a photosensitive planographic printing plate precursor may contain an organic solvent having a boiling point in the range of from 100°C to 300°C for the purpose of enhancing the solubility of the image recording layer components, or the like. However, the content should be adjusted to the range of 2% by mass or less, and it is also preferable that the organic solvent is not included.

If the boiling point of the organic solvent included in the developer liquid is lower than 100°C, the organic solvent is likely to be volatilized, and if the boiling point is higher than 300°C, it is more difficult to concentrate the developer liquid, and it is not preferable.

Regarding the kind of the organic solvent included in the developer liquid, any organic solvent may be used as long as the boiling point is in the range of from 100°C to 300°C, and preferred examples include 2-phenylethanol (boiling point: 219°C), 3-phenyl-1-propanol (boiling point: 238°C), 2-phenoxyethanol (boiling point: 244°C to 255°C), benzyl alcohol (boiling point: 205°C), cyclohexanol (boiling point: 161°C), monoethanolamine (boiling point: 170°C), diethanolamine (boiling point: 268°C), cyclohexanone (boiling point: 155°C), ethyl lactate (boiling point: 155°C), propylene glycol (boiling point: 187°C), ethylene glycol (boiling point: 198°C), γ-butyrolactone (boiling point: 205°C), N-methylpyrrolidone (boiling point: 202°C), N-ethylpyrrolidone (boiling point: 218°C), glycerin (boiling point: 290°C), propylene glycol monomethyl ether (boiling point: 120°C), ethylene glycol monomethyl ether (boiling point: 124°C), ethylene glycol monomethyl ether acetate (boiling point: 145°C), diethylene glycol dimethyl ether (boiling point: 162°C), and glycerin (boiling point: 299°C), and particularly preferred examples include benzyl alcohol, diethanolamine, monoethanolamine, γ-butyrolactone, N-methylpyrrolidone, and N-ethylpyrrolidone.

The amines of the alkali agent that will be described below are also handled as organic solvents in the invention, as long as the boiling points thereof are in the range of from 100°C to 300°C.

### [Organic Acid or Salt Thereof]

It is preferable that the developer liquid according to the invention includes the particular anionic surfactant and/or particular nonionic surfactant described above, and an alkali agent that will be described below, and has a pH value of from 6 to 10.

The pH of the developer liquid may be adjusted using a pH adjusting agent. Regarding the pH adjusting agent, it is preferable that the developer liquid contains an organic carboxylic acid such as citric acid, malic acid, tartaric acid, gluconic acid, benzoic acid, phthalic acid, p-ethylbenzoic acid, p-n-propylbenzoic acid, p-isopropylbenzoic acid, p-n-butylbenzoic acid, p-t-butylbenzoic acid, p-t-butylbenzoic acid, p-2-hydroxyethylbenzoic acid, decanoic acid, salicylic acid or 3-hydroxy-2-naphthoic acid, or a metal salt, ammonium salt, or the like thereof.

Among them, citric acid has a function as a buffering agent, and citric acid is added as, for example, trisodium citrate or tripotassium citrate.

In general, one kind or two or more kinds of the buffering agents are incorporated into the developer liquid in an amount in the range of from 0.05% to 5% by mass, and more preferably from 0.3% to 3% by mass.

### [Water-Soluble Polymer Compound]

Furthermore, in the developer liquid according to the invention, a water-soluble polymer compound may be incorporated in order to reinforce the function of protecting plate surfaces as a gum fluid during the desensitization process that is carried out together with development in a developing bath.

Examples of the water-soluble polymer compound used in the developer liquid according to the invention include soybean polysaccharides, modified starches, gum arabic, dextrin, cellulose derivatives (for example, carboxymethyl cellulose, carboxyethyl cellulose, and methyl cellulose) and modification products thereof, pullulan, polyvinyl alcohol and derivatives thereof, polyvinylpyrrolidone, polyacrylamide and acrylamide copolymers, a vinyl methyl ether/maleic anhydride copolymer, a vinyl acetate/maleic anhydride copolymer, and a styrene/maleic anhydride copolymer. A preferred acid value of the water-soluble polymer compound is from 0 meq/g to 3.0 meq/g.

Regarding the soybean polysaccharides, those conventionally known materials can be used, and for example, there is available SOYAFIBE (manufactured by Fuji Oil Co., Ltd.) as a commercially available product, and products of various grades can be used. A product that can be preferably used is such that the viscosity of a 10 mass% aqueous solution is in the range of from 1 mPa/sec to 100 mPa/sec.

Regarding the modified starches, a compound represented by the following Formula (VII) is preferred. Among the starches represented by Formula (VII), any starch obtained from corn, potato, tapioca, rice, wheat and the like can be used. Modification of these starches can be carried out by a method of decomposing starch using an acid, an enzyme or the like such that the number of glucose residues per molecule would be in the range of from 5 to 30, and further adding oxypropylene in an alkali, or the like.

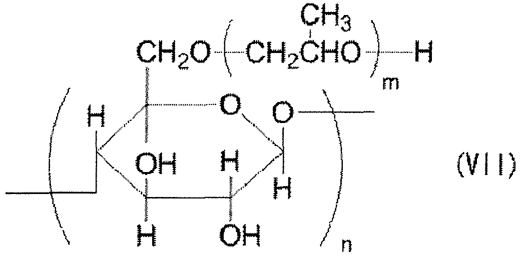

In Formula (VII), the degree of etherification (degree of substitution) is in the range of from 0.05 to 1.2 per glucose unit; n represents an integer from 3 to 30; and m represents an integer from 1 to 3.

Particularly preferred examples among the water-soluble polymer compounds include soybean polysaccharides, modified starches, gum arabic, dextrin, carboxymethyl cellulose, and polyvinyl alcohol.

The water-soluble polymer compounds can be used in combination of two or more kinds. The content of the water-soluble polymer compound in the developer liquid is preferably from 0.1% to 20% by mass, and more preferably from 0.5% to 10% by mass.

### [Chelating Agent]

Furthermore, a chelating agent for a divalent metal may also be incorporated into the developer liquid. Examples of a divalent metal include magnesium and calcium. Examples of the chelating agent include, for example, Na₂P₂O₇, Na₅P₃O₃, Na₃P₃O₉, Na₂O₄P(NaO₃P)PO₃Na₂; polyphosphates such as CALGON (sodium polymetaphosphate); aminopolycarboxylic acids such as, for example, ethylenediaminetetraacetic acid, potassium salt thereof, sodium salt thereof; diethylenetriaminepentaacetic acid, potassium salt thereof, sodium salt thereof; triethylenetetraaminehexaacetic acid, potassium salt thereof, sodium salt thereof; hydroxyethylethylenediaminetriacetic acid, potassium salt thereof, sodium salt thereof; nitrilotriacetic acid, potassium salt thereof, sodium salt thereof; 1,2-diaminocyclohexanetetraacetic acid, potassium salt thereof, sodium salt thereof; 1,3-diamino-2-propanoltetraacetic acid, potassium salt thereof, and sodium salt thereof; as well as organic phosphonic acids such as 2-phosphonobutanetricarboxylic acid-1,2,4, potassium salt thereof, sodium salt thereof; 2-phosphonobutanonetricarboxylic acid-2,3,4, potassium salt thereof, sodium salt thereof; 1-phosphonoethanetricarboxylic acid-1,2,2, potassium salt thereof, sodium salt thereof; 1-hydroxyethane-1,1-diphosphonic acid, potassium salt thereof, sodium salt thereof; aminotri(methylenephosphonic acid), potassium salt thereof, and sodium salt thereof; and biodegradable chelating agents such as, for example, S,S-ethylenediaminedisuccinic acid (EDDS₄H), trisodium S,S-ethylenediaminedisuccinate (EDDS₃Na), and tetrasodium glutamate diacetate.

The content of such a chelating agent in the developer liquid may vary with the hardness and the amount of use of the hard water used in the developer liquid; however, in general, the chelating agent is incorporated in an amount in the range of from 0.01% to 5% by mass, and more preferably from 0.01% to 0.5% by mass, in the developer liquid.

### [Defoamant]

When an anionic surfactant is incorporated into the developer liquid, there is a concern that foaming is likely to occur in particular. Therefore, a defoamant may be added to the developer liquid. In the case of adding a defoamant, it is preferable to add the defoamant in an amount of 0.00001% by mass or more, and it is more preferable to add the defoamant in an amount of from about 0.0001% to 0.5% by mass, with respect to the developer liquid.

In the developer liquid according to the invention, a fluorine-containing defoamant, a silicone-based defoamant, acetylene alcohol, or acetylene glycol may also be incorporated as the defoamant.

Examples of the fluorine-containing defoamant include compounds represented by the formula described below.

Among these, a fluorine-containing defoamant having an HLB value of from 1 to 9, particularly a fluorine-containing defoamant having an HLB value of from 1 to 4, is preferably used. The fluorine-containing defoamants described above are added to the developer liquid directly, or in the form of an emulsion mixed with water or a solvent other than that. 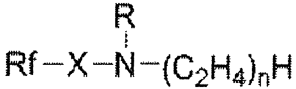 wherein R represents a hydrogen atom or an alkyl group; Rf represents a fluorocarbon group (having from about 5 to 10 carbon atoms) in which some or all of the hydrogen atoms of the alkyl group have been substituted by fluorine atoms; X represents CO or SO₂; and n represents an integer from 1 to 10.

Regarding the silicone-based defoamant, a dialkylpolydioxane, preferably a dimethylpolydioxane described below, is used directly or as a O/W type emulsion: 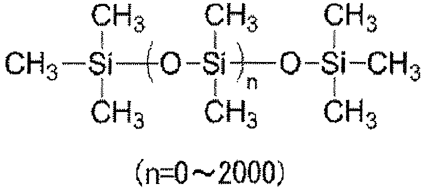 an alkoxypoly(ethyleneoxy)siloxane described below, a dimethylpolydioxane modified by partially introducing carboxylic acid groups or sulfonic acid groups thereto, or an emulsion obtained by mixing such a silicone compound with water together with a compound generally known as an anionic surfactant, is used. 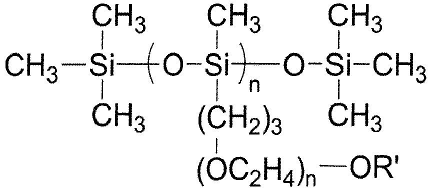 (n: 6 to 10, R': alkyl group having from 1 to 4 carbon atoms) 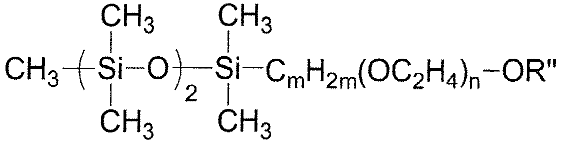 (m: 2 to 4, n: 4 to 12, R": alkyl group having from 1 to 4 carbon atoms)

An acetylene alcohol is an unsaturated alcohol having an acetylene bond (triple bond) in the molecule. Furthermore, an acetylene glycol is also called an alkynediol, and is an unsaturated glycol having an acetylene bond (triple bond) in the molecule.

More specific examples include compounds represented by the following Formulas (1) and (2). 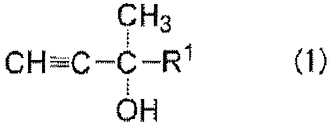 wherein in Formula (1), R¹ represents a linear or branched alkyl group having from 1 to 5 carbon atoms. 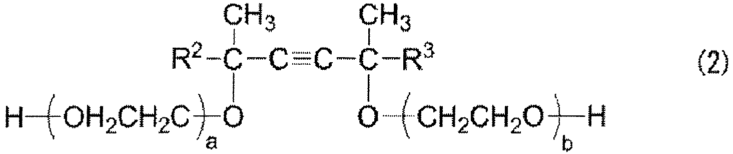 wherein in Formula (2), each of R² and R³ independently represents a linear or branched alkyl group having from 1 to 5 carbon atoms; and a+b represents a number from 0 to 30.

In Formula (2), examples of the linear or branched alkyl group having from 1 to 5 carbon atoms include a methyl group, an ethyl group, an isopropyl group, an isobutyl group, and an isopentyl group.

More specific examples of the acetylene alcohol and the acetylene glycol include the following:
(1) propargyl alcohol
(2) propargyl carbinol
(3) 3,5-dimethyl-1-hexyn-3-ol
(4) 3-methyl-1-butyn-3-ol
(5) 3-methyl-1-pentyn-3-ol
(6) 1,4-butynediol
(7) 2,5-dimethyl-3-hexyne-2,5-diol
(8) 3,6-dimethyl-4-octyne-3,6-diol
(9) 2,4,7,9-tetramethyl-5-decyne-4,7-diol
(10) an ethylene oxide adduct of 2,4,7,9-tetramethyl-5-decyne-4,7-diol (structure show below) 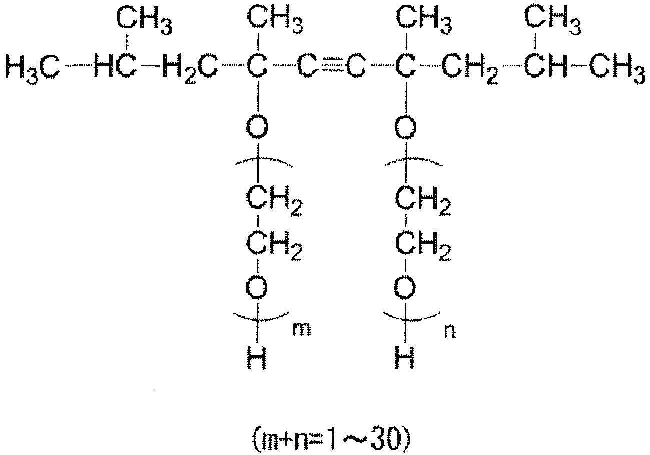
(11) 2,5,8,11-tetramethyl-6-dodecyne-5,8-diol

These acetylene alcohols and acetylene glycols are available from the market, and examples of commercially available products include trade name: SURFINOL manufactured by Air Products and Chemicals, Inc. Specific examples of the commercially available products include, as the item (3) described above, SURFINOL 61; as the item (4), ORFIN B; as the item (5), ORFIN P; as the item (7), ORFIN Y; as the item (8), SURFINOL 82; as the item (9), SURFINOL 104, and ORFIN AK-02; as the item (10), SURFINOL 400 series; and as the item (11), SURFINOL DF-110D.

### [Other Additives]

Furthermore, an alkali metal salt of an organic acid, or an alkali metal salt of an inorganic acid may also be added, as a development regulating agent, to the developer liquid. For example, sodium carbonate, potassium carbonate, ammonium carbonate, sodium citrate, potassium citrate, ammonium citrate, and the like may be used singly or in combination of two or more kinds thereof.

Also, in the developer liquid, as an alkali agent, for example, inorganic alkali agents such as tribasic sodium phosphate, tribasic potassium phosphate, tribasic ammonium phosphate, sodium borate, potassium borate, ammonium borate, sodium hydroxide, potassium hydroxide, ammonium hydroxide, and lithium hydroxide; and organic alkali agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and tetramethylammonium hydroxide, may be used singly or in combination of two or more kinds thereof.

The developer liquid may contain the following additional components if necessary, in addition to the components described above. Examples thereof include a reducing agent, a dye, a pigment, a hard water softening agent, and a preservative.

According to the invention, in order to perform a development process and a desensitization process using a developer liquid in a single bath during the plate-making processing step, the pH of the developer liquid used herein is preferably from 6.0 to 11.0, and more preferably from 8.0 to 10.0, from the viewpoint of the effect.

### (Water)

The remaining component of the developer liquid described above is water. It is advantageous, in view of transportation, to have the developer liquid (developer stock solution) according to the invention prepared as a concentrated liquid with a reduced content of water, so that the concentrated liquid may be diluted with water at the time of use. The degree of concentration in this case is appropriately such that the various components would not undergo separation or precipitation.

In the plate-making processing step, a development process and a desensitization process can be carried out favorably in a single bath by using the developer liquid described above in the developing bath of a general automatic developing machine.

The development process can be carried out by a conventional method at a temperature of from 0°C to 60°C, and preferably from 15°C to 40°C, for example, by a method of immersing an imagewise exposed photosensitive planographic printing plate precursor in a developer liquid, and scrubbing the printing plate precursor with a brush; a method of spraying a developer liquid by spraying, and scrubbing the printing plate precursor with a brush; or the like.

The development processing step according to the invention can be suitably carried out using an automatic development processing machine equipped with a developer liquid supplying means and a scrubbing member. An automatic development processing machine using a rotating brush roll as a scrubbing member is particularly preferred.

It is preferable that two or more rotating brush rolls are used. It is more preferable that the automatic development processing machine includes a means for removing any excess developer liquid, such as a squeeze roller, or a drying means such as a hot air blowing apparatus, after the development processing means. The automatic development processing machine may also include a heating means for heat treating the imagewise exposed photosensitive planographic printing plate precursor, before the development processing means.

Processing with such an automatic development processing machine is advantageous in that there is no need to handle the development residue originating from the protective layer/image recording layer, which is generated in the case of a so-called on-press development process.

### [Waste Liquid Concentrating Step]

In this step, plate-making process waste liquid produced by the plate-making processing step is evaporatively concentrated with a waste liquid concentrating apparatus such that the ratio of the volume of the plate-making process waste liquid after concentration to the volume of the plate-making process waste liquid before concentration would be from 1/2 to 1/10.

Hereinafter, the waste liquid concentrating step according to the invention will be explained.

The waste liquid concentrating apparatus includes at least an evaporating pot (not shown in the diagram) that heats waste liquid without performing pressure reduction or under reduced pressure, and separates the waste liquid into water that evaporates and a concentrate (slurry) that remains; and a cooling pot (not shown in the diagram) that cools and condenses the water separated as water vapor, which may contain an organic solvent, in the evaporating pot, and produces reclaimed water.

It is preferable that concentration of the waste liquid is carried out by a method of reducing the pressure inside the evaporating pot using a pressure reducing means, and heating and concentrating the waste liquid, because the boiling point of the waste liquid is decreased, and the waste liquid can be evaporatively concentrated at a lower temperature than at atmospheric pressure. When a pressure reducing means is used, there is an advantage that it is safer, and the evaporating pot, the waste liquid and the waste liquid concentrate are not easily affected by heat.

Examples of the pressure reducing means include general mechanical vacuum pumps of water seal type, oil rotation type, diaphragm type and the like, diffusion pumps using oil or mercury; compressors such as a multi-stage turbo compressor, a reciprocating compressor, or a screw compressor; and aspirators. Among these, an aspirator is preferably used from the viewpoints of maintenance performance and cost.

Regarding the conditions for pressure reduction, for example, pressure can be reduced to a value of from 666.6 Pa (5 mmHg) to 13332.2 Pa (100 mmHg), and preferably from 666.6 Pa (5 mmHg) to 3999.7 Pa (30 mmHg).

Regarding the heating conditions, a temperature range corresponding to 666.6 Pa to 13332.2 Pa, which is a pressure range that can be easily obtained by a tap aspirator or a vacuum pump, is selected. Specifically, the temperature is in the range of from 20°C to 80°C, and more preferably in the range of from 25°C to 45°C.

When concentration is carried out by performing distillation at a high temperature, a large amount of electric power is needed. Therefore, when pressure is reduced, the heating temperature can be lowered, and the electric power used can be suppressed.

Furthermore, it is also a preferred aspect to use a heat pump as the heating means in the evaporating pot, and regarding the heat pump, an aspect including a heat releasing unit and a heat absorbing unit is preferred. The plate-making process waste liquid is heated by the heat releasing unit of the heat pump, and the water vapor separated from the plate-making process waste liquid can be cooled by the heat absorbing unit of the heat pump. Thus, since heating and concentration of the waste liquid is carried out by heat generation of the heat pump, and condensation of water vapor is carried out by heat absorption of the heat pump, the thermal efficiency is favorable, and as compared with the case of using a heating means such as an electric heater, there are advantages such as that high temperature sites do not occur locally, it is much safer, and the emission amount of carbon dioxide is decreased.

In the present step, when plate-making process waste liquid is evaporatively concentrated in the waste liquid concentrating apparatus, the plate-making process waste liquid is evaporatively concentrated by heating using a heating means inside the evaporating pot, such that a ratio on a volume basis of from 1/2 to 1/10 (= plate-making process waste liquid after concentration/plate-making process waste liquid before concentration) would be achieved. Here, when the concentration ratio is less than 1/2, reduction of the amount of waste liquid to be processed is not effectively achieved, and when the concentration is achieved at a ratio of more than 1/10, precipitation of solids attributable to the concentrated waste liquid is likely to occur in the evaporating pot of the waste liquid concentrating apparatus 30, and there is a concern that maintenance performance may be deteriorated. It is preferable that concentration is achieved in the range of 1/3 to 1/8 on a volume basis. In the above-described range of concentration, less contamination occurs in the concentrating pot, and continuous operation is enabled over a long time period. Also, the reclaimed water thus obtained can be reutilized, and the amount of waste liquid to be discarded as the plate-making process waste liquid is very small.

Meanwhile, as the waste liquid concentrating apparatus used in the present embodiment, commercially available products such as heat pump type concentrating apparatuses, XR-2000 and XR-5000 (all trade names), manufactured by Takagi Refrigerating Co., Ltd., and heating type concentrating apparatuses, FRIENDLY series (trade name), manufactured by Cosmotech Co., Ltd., may be used.

### [Reclaimed Water Producing Step]

In this step, the water vapor separated in the waste liquid concentrating step is condensed, and thus reclaimed water is produced.

As described above, in the waste liquid concentrating step, when heating and concentration of waste liquid is carried out using a heat pump, the water vapor cooled by the heat absorbing unit of the heat pump turns into a liquid state, and reclaimed water can be obtained. That is, reclaimed water is produced in the waste liquid concentrating step.

Furthermore, when heating and concentration of waste liquid has been carried out using a known heating means such as an electric heater, water vapor is condensed using a cooling means, and thus reclaimed water is produced. Regarding the cooling means, a known water cooling cooler or the like may be used as appropriate.

The reclaimed water obtainable as described above is reclaimed water with low BOD and COD values. When the developer liquid used in the invention is put to use, in general, the BOD value is 250 mg/L or less, and the COD value is 200 mg/L or less. Therefore, excess reclaimed water may be discharged directly into common drainage. However, when the reclaimed water contains an organic solvent or the like, the reclaimed water is subjected to a treatment using activated sludge or the like, before being discharged.

Furthermore, similarly to the case of the recycling method of the invention that will be described below, it is also preferable to reutilize reclaimed water by supplying the reclaimed water to the developing bath as diluent water or the like.

### <Method of Recycling Waste Liquid from Plate-Making Process for Photosensitive Planographic Printing Plate Precursor>

A recycling method of the invention comprises:
a plate-making processing step of subjecting a photosensitive planographic printing plate precursor, having a radical polymerizable image recording layer on a support, after exposure simultaneously to a development process and a desensitization process using a developer liquid in a single development processing bath of an automatic developing machine that develops the photosensitive planographic printing plate precursor after exposure, wherein the developer liquid contains from 1% by mass to 10% by mass of a surfactant having a phenyl group or a naphthyl group and at least one of an ethylene oxide group or a propylene oxide group, has a content of an organic solvent having a boiling point in a range of from 100°C to 300°C of 2% by mass or less, and substantially does not contain an organic solvent having a boiling point lower than 100°C or higher than 300°C;
a waste liquid concentrating step of evaporatively concentrating plate-making process waste liquid produced by the plate-making processing step using a waste liquid concentrating apparatus such that a ratio of a volume of the plate-making process waste liquid after concentration to a volume of the plate-making process waste liquid before concentration is from 1/2 to 1/10;
a reclaimed water producing step of producing reclaimed water by condensing water vapor separated in the waste liquid concentrating step; and
a reclaimed water supplying step of supplying the reclaimed water obtained in the reclaimed water producing step to the automatic developing machine.

That is, the recycling method of the invention further includes a reclaimed water supplying step in addition to the plate-making processing step, the waste liquid concentrating step, and the reclaimed water producing step of the method of concentrating plate-making process waste liquid of the invention.

In the recycling method of the invention, the reclaimed water thus produced is supplied to a replenishing water tank or the like, and may be used as diluent water for diluting a developer replenishing liquid at a predetermined ratio inside a developing bath disposed in the automatic developing machine, or may be mixed in advance with a developer replenishing liquid to dilute the developer replenishing liquid at a predetermined ratio.

Furthermore, reclaimed water produced from the plate-making process waste liquid generated from plural automatic developing machines may be collected in a replenishing water tank at one site and used, and may also be supplied from the replenishing water tank to plural automatic developing machines as diluent water or rinsing water.

Specific examples of the apparatus that can be suitably used in the waste liquid concentrating method and the recycling method of the invention include the planographic printing plate-making process waste liquid reducing apparatus described in Japanese Patent No. 4774124, and the waste liquid processing apparatus described in JP-A No. 2011-90282.

Hereinafter, an example of the embodiments according to the invention will be described with reference to the drawings.

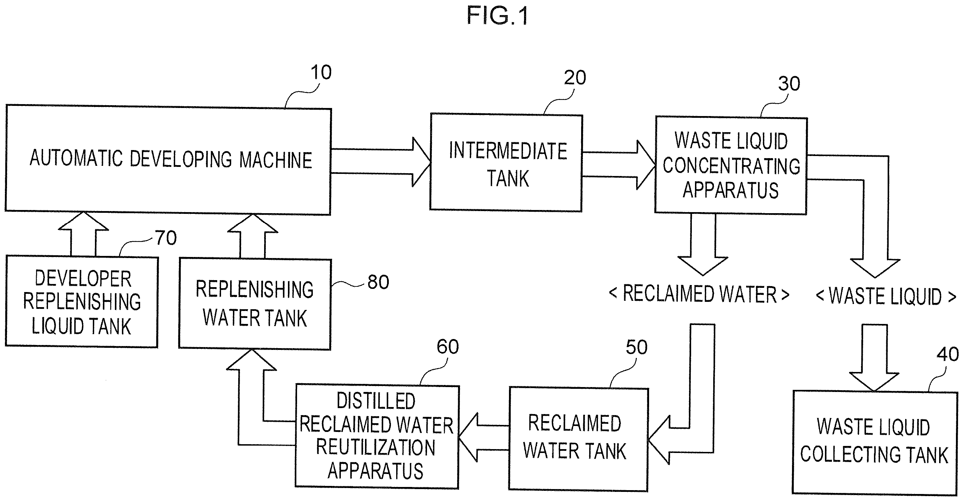

As illustrated in Fig. 1, in the method of recycling plate-making process waste liquid according to the present embodiment, use is made of an automatic developing machine 10; an intermediate tank 20 that stores waste liquid of developer liquid discharged from the automatic developing machine 10 as a result of a plate-making process of a photosensitive planographic printing plate precursor; and a waste liquid concentrating apparatus 30 that heats, without performing pressure reduction or under reduced pressure, the waste liquid sent from the intermediate tank 20, separates the waste liquid into evaporating water vapor and a remaining concentrate (slurry), and also cools and condenses the separated water vapor, thereby producing reclaimed water. Reclaimed water is introduced into a reclaimed water tank 50. The waste liquid concentrated in the waste liquid concentrating apparatus 30 is collected into a waste liquid collecting tank 40. Transport of the concentrated waste liquid to the waste liquid tank 40 is preferably carried out by applying pressure using a pump.

The waste liquid concentrating apparatus 30 includes at least an evaporating pot (not shown in the diagram) that heats, without performing pressure reduction or under reduced pressure, the waste liquid sent from the intermediate tank 20, and separates the waste liquid into evaporating water vapor and a remaining concentrate (slurry); and a cooling pot (not shown in the diagram) that cools and condenses the water separated as water vapor (may include an organic solvent) in the evaporating pot, and thereby produces reclaimed water.

The system includes a reclaimed water tank 50 that temporarily stores the reclaimed water thus separated, and a distilled reclaimed water reutilization apparatus 60 that controls the supply of the reclaimed water to the automatic developing machine 10. The distilled reclaimed water reutilization apparatus 60 preferably includes a replenishing water tank 80 that supplies the reclaimed water to the automatic developing machine 10; a piping; a pressure gauge that measures the pressure inside the piping; and a pump. The apparatus may also include a means that has an analyzer, analyzes the components of the reclaimed water, and performs neutralization, supply of fresh water, and the like according to the components, thereby regulating the composition.

The reclaimed water thus collected is supplied from the replenishing water tank 80 to the automatic developing apparatus 10 by controlling the driving of the pump according to the pressure value measured with the pressure gauge equipped in the distilled reclaimed water reutilization apparatus 60. The automatic developing machine 10 is supplied with a developer replenishing liquid from a developer replenishing liquid tank 70.

The reclaimed water obtained by this system may contain an organic solvent in an amount of 0.5% or less by volume.

The reclaimed water thus obtained is reclaimed water with low BOD and COD values. When the developer liquid used in the invention is used, in general, the BOD value is 250 mg/L or less, and the COD value is 200 mg/L or less. Therefore, excess reclaimed water may be discharged directly into common drainage, in addition to being used as diluent water for evaporation correction in the automatic developing machine, diluent water for developer replenishing liquid, rinsing water for washing the plate, or washing water of the automatic developing machine.

According to the invention, the developer replenishing liquid is diluted and supplied to a developing bath of the automatic developing machine 10. Fig. 1 illustrates an aspect in which the amount of the reclaimed water supplied from the replenishing water tank 80 is controlled according to the amount of supply from the developer replenishing liquid tank 70, and the developer replenishing liquid is diluted at a predetermined ratio in a developing bath (not shown in the diagram) disposed in the automatic developing machine 10; however, the invention is not intended to be limited to this aspect, and the developer replenishing liquid and the reclaimed water may be mixed in advance to dilute the developer replenishing liquid at a predetermined ratio, and then the mixture may be supplied to the developing bath.

Furthermore, it is also acceptable that the plate-making process waste liquid generated from plural automatic developing machines are collected in one waste liquid concentrating apparatus, and the reclaimed water thus obtained is supplied to plural automatic developing machines as diluent water or rinsing water.

As such, the invention is also advantageous in that when the reclaimed water is utilized as replenishing water, the throughput of the photosensitive planographic printing plate precursor that is appropriately plate-making processed is increased, without further supplying fresh diluent water or the like.

### [Photosensitive Planographic Printing Plate Precursor]

Hereinafter, the photosensitive planographic printing plate precursor that can be preferably applied in the method of recycling plate-making process waste liquid of the invention will be described in detail.

Regarding the photosensitive planographic printing plate precursor according to the invention, any printing plate precursor having a radical polymerizable image recording layer on a hydrophilic support can be used without any particular limitations.

The radical polymerizable image recording layer usually contains (A) a polymerization initiator, (B) a polymerizable compound, and (C) a sensitizing colorant, and if desired, further contains (D) a binder polymer. It is preferable that the photosensitive planographic printing plate precursor includes, on the support, a radical polymerizable image recording layer and a protective layer in this sequence.

Hereinafter, the components included in the image recording layer of the photosensitive planographic printing plate precursor according to the invention will be described in order.

### (A) Polymerization Initiator

The image recording layer contains a polymerization initiator (hereinafter, also referred to as initiator compound). In this invention, a radical polymerization initiator is preferably used.

Regarding the initiator compound, any compound known to those ordinarily skilled in the art can be used without any limitations, and specific examples include a trihalomethyl compound, a carbonyl compound, an organic peroxide, an azo compound, an azide compound, a metallocene compound, a hexaarylbiimidazole compound, an organoboron compound, a disulfone compound, an oxime ester compound, an onium salt compound, and an iron-arene complex. Among them, the initiator compound is preferably at least one selected from the group consisting of a hexaarylbiimidazole compound, an onium salt compound, a trihalomethyl compound, and a metallocene compound, and particularly preferably a hexaarylbiimidazole compound. The polymerization initiators can be appropriately used in combination of two or more kinds thereof.

Examples of the hexaarylbiimidazole compound include the lophine dimers described in European Patent No. 24,629, European Patent No. 10,7792, and US Patent No. 4,410,621; for example, 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole, and 2,2'-bis(o-trifluoromethylphenyl)-4,4',5,5'-tetraphenylbiimidazole.

It is particularly preferable to use the hexaarylbiimidazole compound in combination with a sensitizing colorant having a maximum absorption at from 300 nm to 450 nm.

Regarding the onium salt compound, a sulfonium salt, an iodonium salt, and a diazonium salt are preferably used. Particularly, a diaryliodonium salt and a triarylsulfonium salt are preferably used.

It is particularly preferable to use the onium salt compound in combination with an infrared absorber having a maximum absorption at from 750 nm to 1400 nm.

Regarding other polymerization initiators, the polymerization initiators described in paragraphs [0071] to [0129] of JP-A No. 2007-206217 can be preferably used.

The polymerization initiators are suitably used singly or in combination of two or more kinds thereof.

The amount of use of the polymerization initiator in the image recording layer is preferably from 0.01% to 20% by mass, more preferably from 0.1% to 15% by mass, and still more preferably from 1.0% by mass to 10% by mass, with respect to the total solid content of the image recording layer.

The "total solid content" according to the present specification means the total amount of components excluding the solvent, among all the components that constitute the image recording layer.

### (B) Polymerizable Compound

The polymerizable compound used in the image recording layer is an addition polymerizable compound having at least one ethylenically unsaturated double bond, and is selected from compounds having at least one, and preferably two or more, terminal ethylenically unsaturated bonds. These are in the chemical form of, for example, a monomer, a prepolymer, that is, a dimer, a trimer and an oligomer, or a mixture thereof, and usually, a polymerizable monomer is used.

Examples of the monomer include unsaturated carboxylic acids (for example, acrylic acid, methacrylic acid, itaconic acid, crotonic acid, isocrotonic acid, and maleic acid), esters thereof, and amides thereof, and an ester between an unsaturated carboxylic acid and a polyhydric alcohol compound, or an amide between an unsaturated carboxylic acid and a polyvalent amine compound is preferably used. Furthermore, an addition reaction product between an unsaturated carboxylic acid ester or amide, each having a nucleophilic substituent such as a hydroxyl group, an amino group or a mercapto group, and a monofunctional or polyfunctional isocyanate or an epoxy compound; and a dehydration condensation reaction product between such an unsaturated carboxylic acid ester or amide and a monofunctional or polyfunctional carboxylic acid, are also suitably used. An addition reaction product between an unsaturated carboxylic acid ester or amide, each having an electrophilic substituent such as an isocyanate group or an epoxy group, and a monofunctional or polyfunctional alcohol, amine or thiol; and a substitution reaction product between an unsaturated carboxylic acid ester or amide, each having a leaving substituent such as a halogen group or a tosyloxy group, and a monofunctional or polyfunctional alcohol, amine or thiol, are also suitable. Still, for example, a group of compounds obtained by substituting the unsaturated carboxylic acids described above with unsaturated phosphonic acid, styrene, vinyl ether, and the like can also be used. These are described in Japanese National-Phase Publication (JP-A) No. 2006-508380, JP-A No. 2002-287344, JP-A No. 2008-256850, JP-A No. 2001-342222, JP-A No. H09-179296, JP-A No. H09-179297, JP-A No. H09-179298, JP-A No. 2004-294935, JP-A No. 2006-243493, JP-A No. 2002-275129, JP-A No. 2003-64130, JP-A No. 2003-280187, and JP-ANo. H10-333321.

Specific examples of the monomer of an ester between a polyhydric alcohol compound and an unsaturated carboxylic acid include, as acrylic acid esters, ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO)-modified triacrylate, and polyester acrylate oligomers. Examples of methacrylic acid esters include tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl]dimethylmethane, and bis-[p-(methacryloxyethoxy)phenyl]dimethylmethane. Specific examples of the monomer of an amide between a polyvalent amine compound and an unsaturated carboxylic acid include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide, and xylylene bismethacrylamide.

Furthermore, various compounds such as those described in paragraphs [0189] to [0208] of JP-A No. 2004-318053 may also be appropriately selected and used.

A urethane-based addition polymerizable compound produced using an addition reaction between an isocyanate group and a hydroxyl group is also suitable, and specific examples thereof include a vinylurethane compound containing two or more polymerizable vinyl groups in one molecule, which is obtained by adding a vinyl monomer containing a hydroxyl group represented by the following Formula (A), to a polyisocyanate compound having two or more isocyanate groups in one molecule, as described in Japanese Patent Publication (JP-B) No. S48-41708.

CH₂ = C(R⁴)COOCH₂CH(R⁵)OH (A)

provided that each of R⁴ and R⁵ represents H or CH₃.

Furthermore, urethane acrylates described in JP-ANo. S51-37193, JP-B No. H02-32293, JP-B No. H02-16765, JP-A No. 2003-344997, and JP-A No. 2006-65210; urethane compounds having an ethylene oxide-based skeleton, described in JP-B No. S58-49860, JP-B No. S56-17654, JP-B No. S62-39417, JP-B No. S62-39418, JP-A No. 2000-250211, and JP-A No. 2007-94138; and urethane compounds having hydrophilic groups, described in US Patent No. 7,153,632, JP-A No. H08-505958, JP-A No. 2007-293221, and JP-A No. 2007-293223, are also suitable.

Furthermore, a polymerizable compound capable of photooxidation as described in JP-A No. 2007-506125 is also suitable, and a polymerizable compound containing at least one urea group and/or tertiary amino group is particularly preferred. Specific examples include compounds described below.

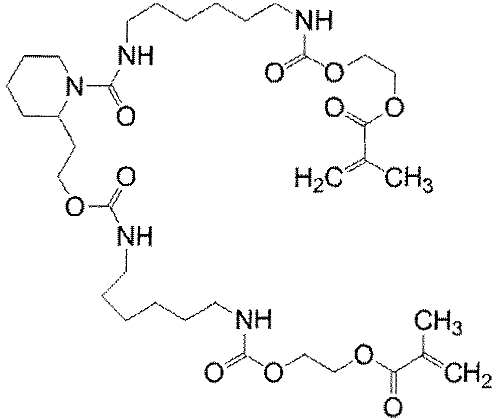

The details of the structure of the polymerizable compound, single use or combined use, the method of use such as the amount of addition can be arbitrarily set in accordance with the final performance design of the photosensitive planographic printing plate precursor.

The polymerizable compound is used in an amount in the range of preferably from 5% to 75% by mass, more preferably from 25% to 70% by mass, and particularly preferably from 30% to 60% by mass, with respect to the total solid content of the image recording layer.

### (C) Sensitizing Colorant

The image recording layer contains a sensitizing colorant. Any sensitizing colorant can be used without any particular limitations as long as the sensitizing colorant absorbs light at the time of image exposure to enter an excited state, donates energy to the polymerization initiator through electron transfer, energy transfer, heat generation or the like, and enhances the polymerization initiation function. Particularly, a sensitizing colorant having a maximum absorption at 300 nm to 450 nm or 750 nm to 1400 nm is preferably used.

Examples of the sensitizing colorant having a maximum absorption in a wavelength range of 300 nm to 450 nm include merocyanines, benzopyrans, coumarins, aromatic ketones, anthracenes, styryls, and oxazoles.

Among the sensitizing colorants having maximum absorptions in a wavelength range of from 300 nm to 450 nm, more preferred examples of the colorant from the viewpoint of high sensitivity include a colorant represented by the following Formula (IX):

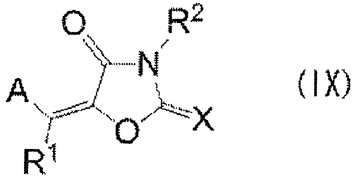

In Formula (IX), A represents an aryl group or heteroaryl group which may have a substituent; X represents an oxygen atom, a sulfur atom, or =N(R³); each of R¹, R², and R³ independently represents a monovalent non-metal atomic group; and A and R¹, or R² and R³ may be bonded to each other to form an aliphatic or aromatic ring.

Formula (IX) will be described in more detail. Each of R¹, R², and R³ independently represents a monovalent non-metal atomic group, and is preferably a hydrogen atom, a substituted or unsubstituted alkyl group, a substituted or unsubstituted alkenyl group, a substituted or unsubstituted aryl group, a substituted or unsubstituted heteroaryl group, a substituted or unsubstituted alkoxy group, a substituted or unsubstituted alkylthio group, a hydroxyl group, or a halogen atom.

Examples of the aryl group or heteroaryl group which may have a substituent, as represented by A in Formula (IX), are the same as the substituted or unsubstituted aryl groups and the substituted or unsubstituted heteroaryl groups described for R¹, R², and R³, respectively.

Specific examples of such a sensitizing colorant that may be preferably used include the compounds described in paragraphs [0047] to [0053] of JP-A No. 2007-58170, paragraphs [0036] to [0037] of JP-A No. 2007-93866, and paragraphs [0042] to [0047] of JP-A No. 2007-72816.

Furthermore, the sensitizing colorants described in JP-A No. 2006-189604, JP-A No. 2007-171406, JP-A No. 2007-206216, JP-A No. 2007-206217, JP-A No. 2007-225701, JP-A No. 2007-225702, JP-A No. 2007-316582, and JP-A No. 2007-328243 can also be preferably used.

Next, the sensitizing colorant having a maximum absorption at 750 nm to 1400 nm (hereinafter, also referred to as "infrared absorber") will be described. For the infrared absorber, a dye or a pigment is preferably used.

Regarding the dye, commercially available dyes and those known dyes described in the literature such as, for example, "Senryo Binran (Handbook of Dyes)" (edited by the Society of Synthetic Organic Chemistry, published in 1970) can be utilized. Specific examples thereof include dyes such as azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts, and metal thiolate complexes.

Among these dyes, particularly preferred examples include cyanine dyes, squarylium dyes, pyrylium salts, nickel thiolate complexes, and indolenine cyanine dyes. Furthermore, cyanine dyes or indolenine cyanine dyes are preferred, and particularly preferred examples include a cyanine dye represented by the following Formula (a):

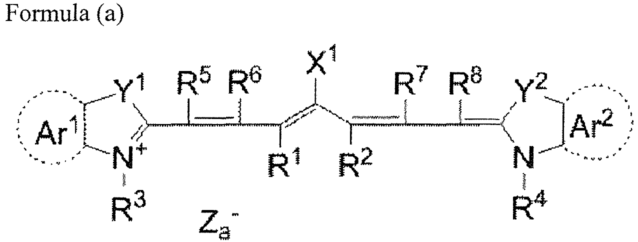

In Formula (a), X¹ represents a hydrogen atom, a halogen atom, -NPh₂, -X²-L¹, or a group shown below. Here, X² represents an oxygen atom, a nitrogen atom, or a sulfur atom, and L¹ represents a hydrocarbon group having from 1 to 12 carbon atoms, an aryl group having a heteroatom (N, S, O, halogen atom, or Se), or a hydrocarbon group having from 1 to 12 carbon atoms and containing a heteroatom. Xₐ⁻ has the same definition as Zₐ⁻ that will be described below, and R^{a} represents a substituent selected from a hydrogen atom, an alkyl group, an aryl group, a substituted or unsubstituted amino group, and a halogen atom.

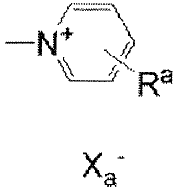

Each of R¹ and R² independently represents a hydrocarbon group having from 1 to 12 carbon atoms. In view of storage stability of the image recording layer coating liquid, R¹ and R² are preferably hydrocarbon groups each having two or more carbon atoms. R¹ and R² may also be linked to each other and form a ring, and when they form a ring, it is particularly preferable that they form a 5-membered ring or a 6-membered ring.

Ar¹ and Ar² may be identical with or different from each other, and each represents an aryl group which may have a substituent. Preferred examples of the aryl group include a benzene ring and a naphthalene ring. Also, preferred examples of the substituent include a hydrocarbon group having 12 or fewer carbon atoms, a halogen atom, and an alkoxy group having 12 or fewer carbon atoms. Y¹ and Y² may be identical with or different from each other, and each represents a sulfur atom, or a dialkylmethylene group having 12 or fewer carbon atoms. R³ and R⁴ may be identical with or different from each other, and each represents a hydrocarbon group having 20 or fewer carbon atoms which may have a substituent. Preferred examples of the substituent include an alkoxy group having 12 or fewer carbon atoms, a carboxyl group, and a sulfo group. R⁵, R⁶, R⁷, and R⁸ may be identical with or different from each other, and each represents a hydrogen atom, or a hydrocarbon group having 12 or fewer carbon atoms. In view of the availability of the raw material, it is preferably a hydrogen atom. Also, Zₐ⁻ represents a counter anion.

However, when the cyanine dye represented by Formula (a) has an anionic substituent in the structure, and neutralization of the charge is not needed, Zₐ⁻ is not necessary. Preferred examples of Zₐ⁻ include, from the viewpoint of storage stability of the image recording layer coating liquid, a halogen ion, a perchlorate ion, a tetrafluoroborate ion, a hexafluorophosphate ion, and a sulfonate ion, and particularly preferred examples include a perchlorate ion, a hexafluorophosphate ion, and an arylsulfonate ion.

Specific examples of the cyanine dye represented by Formula (a) that can be suitably used include the compounds described in paragraphs [0017] to [0019] of JP-A No. 2001-133969, paragraphs [0016] to [0021] of JP-A No. 2002-023360, and paragraphs [0012] to [0037] of JP-A No. 2002-040638; preferred examples include the compounds described in paragraphs [0034] to [0041] of JP-A No. 2002-278057, and paragraphs [0080] to [0086] of JP-A No. 2008-195018; and particularly preferred examples include the compounds described in paragraphs [0035] to [0043] of JP-A No. 2007-90850.

Furthermore, the compounds described in paragraphs [0008] to [0009] of JP-A No. H05-5005 and paragraphs [0022] to [0025] of JP-A No. 2001-222101 can also be preferably used.

The infrared absorbing dyes may be used singly or in combination of two or more kinds thereof, and an infrared absorber other than an infrared absorbing dye, such as a pigment, may also be used in combination. Preferred examples of the pigment include the compounds described in paragraphs [0072] to [0076] of JP-A No. 2008-195018.

A preferred amount of addition of the sensitizing colorant is preferably from 0.05 parts to 30 parts by mass, more preferably from 0.1 parts to 20 parts by mass, and particularly preferably from 0.2 parts to 10 parts by mass, with respect to 100 parts by mass of the total solid content of the image recording layer.

### (D) Binder Polymer

The image recording layer may contain a binder polymer.

Regarding the binder polymer, use is made of a polymer which can support the image recording layer components on a support and can be removed by a developer liquid. Examples of the binder polymer that may be used include a (meth)acrylic polymer, a polyurethane resin, a polyvinyl alcohol resin, a polyvinyl butyral resin, a polyvinyl formal resin, a polyamide resin, a polyester resin, and an epoxy resin. Particularly, a (meth)acrylic polymer, a polyurethane resin, and a polyvinyl butyral resin are preferably used.

According to the invention, a "(meth)acrylic polymer" refers to a copolymer having a (meth)acrylic acid derivative such as (meth)acrylic acid, a (meth)acrylic acid ester (an alkyl ester, an aryl ester, an allyl ester, or the like), (meth)acrylamide, or a (meth)acrylamide derivative, as a polymerization component. A "polyurethane resin" refers to a polymer produced by a condensation reaction between a compound having two or more isocyanate groups and a compound having two or more hydroxyl groups. A "polyvinyl butyral resin" refers to a polymer synthesized by allowing a polyvinyl alcohol that is obtained by partially or fully saponifying polyvinyl acetate, to react with butyl aldehyde under acidic conditions (acetalization reaction), and also includes a polymer in which an acid group or the like has been introduced by a method of allowing residual hydroxyl groups to react with a compound having an acid group or the like.

A suitable example of the (meth)acrylic polymer according to the invention may be a copolymer having a repeating unit containing an acid group. Examples of the acid group include a carboxylic acid group, a sulfonic acid group, a phosphonic acid group, a phosphoric acid group, and a sulfonamide group, but particularly, a carboxylic acid group is preferred. Regarding the repeating unit containing an acid group, a repeating unit derived from (meth)acrylic acid, or a repeating unit represented by the following Formula (i) is preferably used.

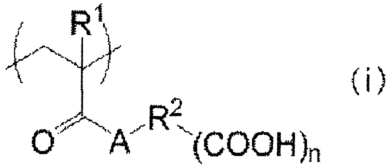

In Formula (i), R¹ represents a hydrogen atom or a methyl group; R² represents a single bond or a linking group having a valence of n+1; A represents an oxygen atom or -NR³-; R³ represents a hydrogen atom or a monovalent hydrocarbon group having from 1 to 10 carbon atoms; and n represents an integer from 1 to 5.

The linking group represented by R² in Formula (i) is composed of a hydrogen atom, a carbon atom, an oxygen atom, a nitrogen atom, a sulfur atom and a halogen atom, and the number of atoms is preferably from 1 to 80.

The proportion (mol%) of the copolymerization component having a carboxylic acid group among all the copolymerization components of the (meth)acrylic polymer is preferably from 1% to 70% from the viewpoint of developability. When a balance between developability and printing durability is considered, the proportion is more preferably 1% to 50%, and particularly preferably from 1% to 30%.

Such binder polymers are described in paragraphs [0018] to [0127] of JP-A No. 2004-318053, and the compounds described herein are suitably used as binder polymers in this invention.

The (meth)acrylic polymer used as a binder polymer may further have a crosslinkable group. The crosslinkable group is not particular limited as long as it is a group capable of crosslinking a polymer during the course of a radical polymerization reaction occurring in the image recording layer when the photosensitive planographic printing plate precursor is exposed, and examples of the functional group capable of addition polymerization reaction include an ethylenically unsaturated bond group, an amino group, and an epoxy group. Furthermore, the crosslinkable group may also be a functional group which can be converted to a radical by light irradiation, and examples of such a crosslinkable group include a thiol group and a halogen group. Among them, an ethylenically unsaturated bond group is preferred. The ethylenically unsaturated bond group is preferably a styryl group, a (meth)acryloyl group, or an allyl group.

The content of the crosslinkable group in the (meth)acrylic polymer (content of radical polymerizable unsaturated double bonds based on iodine titration) is preferably from 0.01 mmol to 10.0 mmol, and more preferably from 0.05 mmol to 9.0 mmol, and particularly preferably from 0.1 mmol to 8.0 mmol, per gram of the polymer.

Suitable examples of the polyurethane resin used as the binder polymer according to the invention include the polyurethane resins described in paragraphs [0099] to [0210] of JP-A No. 2007-187836, paragraphs [0019] to [0100] of JP-A No. 2008-276155, paragraphs [0018] to [0107] of JP-ANo. 2005-250438, and paragraphs [0021] to [0083] of JP-ANo. 2005-250158.

Suitable examples of the polyvinyl butyral resin used as the binder polymer in the invention include the polyvinyl butyral resins described in paragraphs [0006] to [0013] of JP-A No. 2001-75279.

A portion of the acid groups in the binder polymer may be neutralized with a basic compound. Examples of the basic compound include a compound containing basic nitrogen, alkali metal hydroxides, and quaternary ammonium salts of alkali metals.

The binder polymer preferably has a mass average molecular weight of 5000 or more, and more preferably from 10,000 to 300,000, and preferably has a number average molecular weight of 1000 or more, and more preferably from 2000 to 250,000. The dispersity (mass average molecular weight/number average molecular weight) is preferably from 1.1 to 10.

The binder polymers may be used singly, or may be used as a mixture of two or more kinds.

When a binder polymer is used in the image recording layer, from the viewpoints of having favorable strength of the image area and image formability, the content of the binder polymer is preferably from 5% to 75% by mass, more preferably from 10% to 70% by mass, and still more preferably from 10% to 60% by mass, with respect to the total solid content of the image recording layer.

The total content of the polymerizable compound and the binder polymer is preferably 90% by mass or less with respect to the total solid content of the image recording layer. If the total content is more than 90% by mass, a decrease in sensitivity and a decrease in developability may occur. The total content is more preferably from 35% to 80% by mass.

### (Chain Transfer Agent)

It is preferable that the image recording layer contains a chain transfer agent. The chain transfer agent is defined in, for example, Kobunshi Jiten (Polymer Dictionary), 3rd Edition (edited by the Society of Polymer Science, Japan, 2005), pp. 683 to 684. Regarding the chain transfer agent, for example, a group of compounds having SH, PH, SiH or GeH in the molecule are used. These can produce a radical by donating hydrogen to a less active radical species, or can produce a radical by being oxidized and then deprotonated. In the image recording layer according to the invention, thiol compounds (for example, 2-mercaptobenzimidazoles, 2-mercaptobenzothiazoles, 2-mercaptobenzoxazoles, 3-mercaptotriazoles, and 5-mercaptotetrazoles) can be particularly preferably used.

The amount of addition of the chain transfer agent is preferably from 0.01 parts to 20 parts by mass, more preferably from 1 part to 10 parts by mass, and particularly preferably from 1 part to 5 parts by mass, with respect to 100 parts by mass of the total solid content of the image recording layer.

### (Other Image Recording Layer Components)

In the image recording layer, various additives can be further incorporated if necessary. Examples of the additives include a surfactant for promoting developability and enhancing the coated surface state; microcapsules for achieving a balance between developability and printing durability; a hydrophilic polymer for enhancing developability or enhancing dispersion stability of microcapsules; a colorant or a printing agent for visualizing image areas and non-image areas; a polymerization inhibitor for preventing unnecessary thermal polymerization of the radical polymerizable compound during production of the image recording layer or during storage; a hydrophobic low molecular weight compound such as a higher fat derivative for preventing polymerization inhibition by oxygen; inorganic fine particles or organic fine particles for increasing the cured film strength of the image areas; a hydrophilic low molecular weight compound for enhancing developability; a co-sensitizer for enhancing sensitivity; and a plasticizer for enhancing plasticity. For these additives, all known compounds, for example, the compounds described in paragraphs [0161] to [0215] of JP-ANo. 2007-206217, paragraph [0067] of JP-ANo. 2005-509192, and paragraphs [0023] to [0026] and [0059] to [0066] of JP-ANo. 2004-310000, can be used. Regarding the surfactant, those surfactants which may be added to the developer liquid that will be described below can be used.

### <Formation of Image Recording Layer>

The image recording layer is formed by dispersing or dissolving the various necessary components described above in a solvent to prepare a coating liquid, and applying the coating liquid. Examples of the solvent that may be used include, but are not limited to, methyl ethyl ketone, ethylene glycol monomethyl ether, 1-methoxy-2-propanol, 2-methoxyethyl acetate, 1-methoxy-2-propyl acetate, and γ-butyrolactone. The solvents may be used singly or as mixtures. The solid content concentration of the coating liquid is preferably from 1% to 50% by mass.

The amount of coating (solid content) of the image recording layer obtainable after coating and drying is preferably from 0.3 g/m² to 3.0 g/m². Various methods can be used for the coating. Examples include bar coater coating, spin coating, spray coating, curtain coating, dip coating, air knife coating, blade coating, and roll coating.

### <Protective Layer>

The photosensitive planographic printing plate precursor according to the invention is provided with a protective layer (oxygen blocking layer) on the image recording layer, in order to block diffusion and penetration of oxygen that impedes the polymerization reaction at the time of exposure. Regarding the material of the protective layer, any of a water-soluble polymer and a water-insoluble polymer can be appropriately selected and used, and if necessary, a mixture of two or more kinds can be used. Specific examples include polyvinyl alcohol, modified polyvinyl alcohol, polyvinylpyrrolidone, a water-soluble cellulose derivative, and poly(meth)acrylonitrile. Among these, it is preferable to use a water-soluble polymer having relatively excellent crystallinity, and specifically, when polyvinyl alcohol is used as a main component, the most favorable results are obtained in terms of fundamental characteristics such as oxygen blocking properties and development removability.

The polyvinyl alcohol used in the protective layer may be partially substituted with an ester, an ether or an acetal, as long as the polyvinyl alcohol contains unsubstituted vinyl alcohol units for having the necessary oxygen blocking properties and water-solubility. Similarly, the polyvinyl alcohol may also partially have other copolymerization components. Polyvinyl alcohol may be obtained by hydrolyzing polyvinyl acetate, and a specific example of the polyvinyl alcohol may be a polyvinyl alcohol having a degree of hydrolysis of from 69.0 mol% to 100 mol% and a number of polymerization repeating units in the range of from 300 to 2400. Specific examples include the compounds described in paragraphs [0233] to [0234] of JP-A No. 2004-318053.

The percentage content of the polyvinyl alcohol in the protective layer is preferably from 20% to 95% by mass, and more preferably from 30% to 90% by mass.

Furthermore, any known modified polyvinyl alcohol can also be preferably used. Particularly, an acid-modified polyvinyl alcohol having a carboxylic acid group or a sulfonic acid group is preferably used. Specifically, suitable examples include the polyvinyl alcohols described in JP-ANo. 2005-250216 and JP-ANo. 2006-259137.

When polyvinyl alcohol is used as a mixture with another material, the component to be mixed therewith is preferably a modified polyvinyl alcohol, polyvinylpyrrolidone, or a modification product thereof, from the viewpoints of oxygen blocking properties and development removability. The content thereof in the protective layer is from 3.5% to 80% by mass, preferably from 10% to 60% by mass, and more preferably from 15% to 30% by mass.

Furthermore, it is also preferable to incorporate an inorganic layered compound into the protective layer, for the purpose of enhancing the oxygen blocking properties or the image recording layer surface protectiveness. Among inorganic layered compounds, fluorine-containing swellable synthetic mica which is a synthetic inorganic layered compound is particularly useful. Specifically, suitable examples include inorganic layered compounds described in JP-ANo. 2005-119273.

The amount of coating of the protective layer is preferably 0.05 g/m² to 10 g/m² as the amount of coating after drying, and when the protective layer contains an inorganic layered compound, the amount of coating is more preferably from 0.1 g/m² to 5 g/m², while when the protective layer does not contain an inorganic layered compound, the amount of coating is more preferably from 0.5 g/m² to 5 g/m².

### <Support>

The support that is used in the photosensitive planographic printing plate precursor is not particularly limited, and a plate-shaped hydrophilic support which is dimensionally stable is acceptable. Particularly, an aluminum plate is preferred. Before the aluminum plate is used, it is preferable to apply a surface treatment such as a surface roughening treatment or an anodization treatment. The surface roughening treatment of the aluminum plate surface is carried out by various methods, and examples include a mechanical surface roughening treatment, an electrochemical surface roughening treatment (surface roughening treatment of dissolving the surface electrochemically), and a chemical surface roughening treatment (surface roughening treatment of selectively dissolving the surface chemically). In regard to these treatments, the methods described in paragraphs [0241] to [0245] of JP-ANo. 2007-206217 can be preferably used.

The support preferably has a center line average roughness of from 0.10 µm to 1.2 µm. In this range, favorable adhesiveness to the image recording layer, favorable printing durability, and favorable uncontaminability are obtained.

The color density of the support is preferably from 0.15 to 0.65 as a reflection density value. With this range, favorable image formability caused by the prevention of halation at the time of image exposure, and favorable plate inspectability after development, are obtained.

The thickness of the support is preferably from 0.1 mm to 0.6 mm, and more preferably from 0.15 mm to 0.4 mm.

### (Support Hydrophilization Treatment and Undercoat Layer)

In regard to the photosensitive planographic printing plate precursor, in order to enhance hydrophilicity of non-image areas and to prevent print contamination, it is also suitable to perform a hydrophilization treatment of the support surface, or to provide an undercoat layer between the support and the image recording layer.

Examples of the hydrophilization treatment of the support surface include an alkali metal silicate treatment method of subjecting the support to an immersion treatment in an aqueous solution of sodium silicate or the like, or to an electrolytic treatment; a method of treating the support with potassium fluorozirconate; and a method of treating the support with polyvinylphosphonic acid. However, a method of subjecting the support to an immersion treatment in an aqueous solution of polyvinylphosphonic acid is preferably used.

Regarding the undercoat layer, an undercoat layer including a compound having an acidic group, such as phosphonic acid, phosphoric acid or sulfonic acid, is preferably used. These compounds preferably further contain polymerizable groups in order to increase the adhesiveness to the image recording layer. The polymerizable group is preferably an ethylenically unsaturated bond group. Furthermore, a compound having a hydrophilicity imparting group such as an ethyleneoxy group may also be listed as a suitable compound.

These compounds may be low molecular weight compounds, or may be high molecular weight polymers. These compounds may be used in combination of two or more kinds thereof if necessary.

Suitable examples include a silane coupling agent having an addition polymerizable ethylenically unsaturated bond group described in JP-ANo. H10-282679; and a phosphorus compound having an ethylenically unsaturated bond group described in JP-ANo. H02-304441. Undercoat layers containing lower molecular weight or high molecular weight compounds having a crosslinkable group (preferably, an ethylenically unsaturated bond group), a functional group that interacts with the support surface, and a hydrophilic group as described in JP-ANo. 2005-238816, JP-ANo. 2005-125749, JP-ANo. 2006-239867, and JP-ANo. 2006-215263 are also preferably used.

The undercoat layer is applied by a known method. The amount of coating (solid content) of the undercoat layer is preferably from 0.1 mg/m² to 100 mg/m², and more preferably from 1 mg/m² to 40 mg/m².

### <Back Coat Layer>

If necessary, a back coat can be provided on the back surface of the support (surface on the opposite side from the image recording layer). Suitable examples of the back coat include a layer formed from the organic polymer compound described in JP-ANo. H05-45885; and a coating layer formed from a metal oxide obtainable by hydrolysis and polycondensation of an organometallic compound or an inorganic metal compound described in JP-ANo. H06-35174. Among them, it is preferable to use an alkoxy compound of silicon such as Si(OCH₃)₄, Si(OC₂H₅)₄, Si(OC₃H₇)₄, or Si(OC₄H₉)₄, from the viewpoint that the raw materials are available at low cost.

### [Plate-Making Method]

A planographic printing plate is produced by subjecting the photosensitive planographic printing plate precursor according to the invention to imagewise exposure and development processing. In the waste liquid concentrating method of the invention and the recycling method of the invention, a development process and a desensitization process are simultaneously carried out using a developer liquid in a single development processing bath of an automatic developing machine.

### [Imagewise Exposure Step]

The photosensitive planographic printing plate precursor is imagewise exposed by laser exposing through a transparent original image having a line image, a halftone image and the like, or by laser light scanning based on digital data.

The wavelength of the light source is preferably from 300 nm to 450 nm, or from 750 nm to 1400 nm. In the case of 300 nm to 450 nm, a photosensitive planographic printing plate precursor including a sensitizing colorant having a maximum absorption in this region in the image recording layer is used, and in the case of 750 nm to 1400 nm, a photosensitive planographic printing plate precursor containing an infrared absorber which is a sensitizing colorant having absorption in this region is used. Regarding a light source at 300 nm to 450 nm, semiconductor lasers are suitable. Regarding a light source at 750 nm to 1400 nm, solid lasers and semiconductor lasers that emit infrared radiation are suitable. The exposure mechanism may be any of an internal drum system, an external drum system, a flat bed system, and the like.

### [Development Processing Method]

The developer liquid described above can be used as a developer liquid and developer replenishing liquid for exposed photosensitive planographic printing plate precursors, and it is preferable to apply the developer liquid to a developing bath of an automatic processing machine as described above.

In the case of performing development using an automatic processing machine, since the developer liquid is fatigued according to the throughput, the processing ability may be restored by using a replenishing liquid or a fresh developer liquid. This replenishing system is preferably applied also to the recycling method of the invention.

Development processing can be carried out suitably by an automatic processing machine equipped with a means for supplying a developer liquid, and a scrubbing member.

Particularly, when a protective layer containing the polyvinyl alcohol is provided on the image recording layer, a photosensitive planographic printing plate precursor can be subjected, after laser exposure, without going through a water washing step, to a development process for removing the protective layer and the image recording layer in unexposed areas, and a desensitization process of the surface of the image areas thus formed, in a single bath, using a developer liquid containing the particular surfactant described above and preferably having a pH of from 6 to 10. When compared with a conventional method of performing these processes in sequence as separate steps, the amount of the process waste liquid is further reduced.

Furthermore, the protective layer can be optionally removed by applying a water-washing process in advance, prior to the development process.

Furthermore, in the development processing step described above, the protective layer and the image recording layer in unexposed areas are both removed, and the image areas thus formed is subjected to a desensitization process. Therefore, the planographic printing plate obtained after the development process can be immediately mounted on a printing machine and subjected to printing.

That is, since a development process and a desensitization process are carried out in a single bath by incorporating a particular surfactant into the developer liquid, a post-washing step with water is not particularly necessary, and a drying step can be carried out immediately. After the development process, it is preferable to perform drying after removing any excess developer liquid using a squeeze roller.

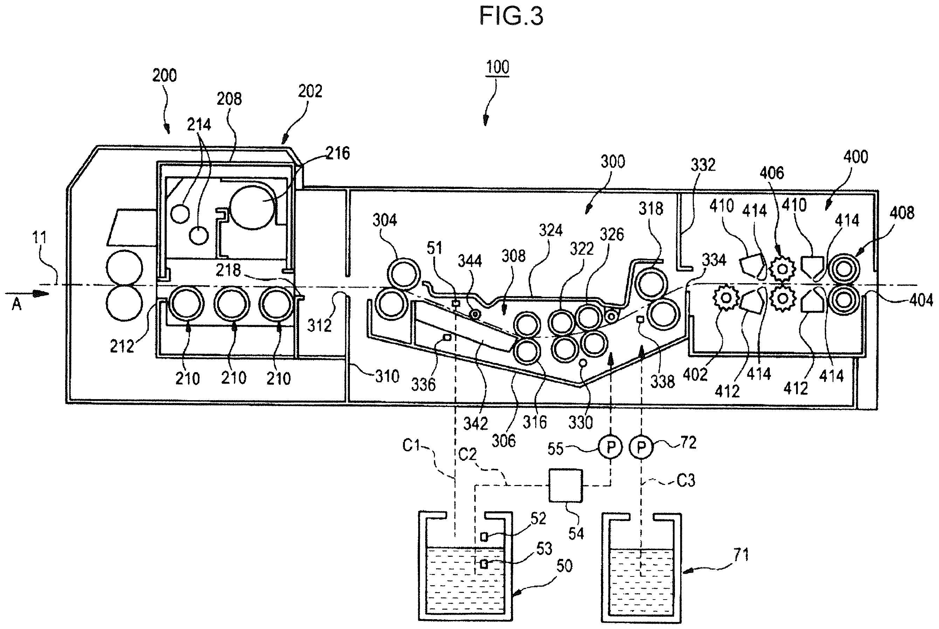

An example of the automatic development processing machine used in the method of producing a planographic printing plate of the invention will be described briefly with reference to Fig. 3.

The automatic development processing machine 100 illustrated in Fig. 3 is composed of a chamber in which an external shape is formed by a frame 202, and includes a preheating (preheat) section 200, a development section 300, and a drying section 400 that are formed continuously along the conveyance direction (arrow A) of a conveyance path 11 for the photosensitive planographic printing plate precursor.

The preheating section 200 has a heating chamber 208 having an inlet port 212 and an outlet port 218, and disposed inside the heating chamber are skewer type rollers 210, a heater 214, and a circulating fan 216.

The development section 300 is separated from the preheating section 200 by an outer panel 310, and the outer panel 310 is provided with a slit-like insertion opening 312.

Inside the development section 300, a processing tank 306 having a developing bath 308 filled with a developer liquid, and a pair of inserting rollers 304 that guide the photosensitive planographic printing plate precursor into the inside of the processing tank 306 are provided. The top of the developing bath 308 is covered with a cover lid 324.

Inside the developing bath 308, a guide roller 344, a guide member 342, a pair of in-liquid rollers 316, a pair of brush rollers 322, a pair of brush rollers 326, and a pair of export rollers 318 are provided in order from the upstream side of the conveyance direction. The photosensitive planographic printing plate precursor conveyed to the inside of the developing bath 308 is passed through between the pairs of brush rollers 322 and 326 that rotate while being immersed in the developer liquid, and thereby non-image areas are removed.

Provided below the pairs of brush rollers 322 and 326 is a spray pipe 330. The spray pipe 330 is connected with a pump (not shown in the diagram), and the developer liquid in the developing bath 308 that has been suctioned by the pump is spouted into the developing bath 308 from the spray pipe 330.

The side wall of the developing bath 308 is provided with an overflow opening 51 formed at the upper end of a first circulation pipe C1, and an excess amount of the developer liquid flows into the overflow opening 51, passes through the first circulation pipe C1, and is discharged to an external tank 50 provided outside the development section 300.

The external tank 50 is connected with a second circulation pipe C2, and a filter unit 54 and a developer liquid supplying pump 55 are provided in the second circulation pipe C2. The developer liquid is supplied from the external tank 50 to the developing bath 308 by the developer liquid supplying pump 55. Also, an upper limit liquid level gauge 52 and a lower limit liquid level gauge 53 are provided inside the external tank 50.

The developing bath 308 is connected to a replenishing water tank 71 through a third circulation pipe C3. Provided in the third circulation pipe C3 is a water replenishing pump 72, and the water stored in the replenishing water tank 71 is supplied to the developing bath 308 by this water replenishing pump 72.

A liquid temperature sensor 336 is provided on the upstream side of the pair of in-liquid rollers 316, and a liquid level gauge 338 is provided on the upstream side of the pair of export rollers 318.

A slit-like insertion opening 334 is provided on a partition plate 332 that is disposed between the development section 300 and the drying section 400. Also, a shutter (not shown in the diagram) is provided in the pathway between the development section 300 and the drying section 400, and the pathway is closed by the shutter when the planographic printing plate does not pass through the pathway.

The drying section 400 includes a supporting roller 402, ducts 410 and 412, a pair of conveying rollers 406, ducts 410 and 412, and a pair of conveying rollers 408 provided therein in this order. Slit openings 414 are provided at the ends of the ducts 410 and 412. Also, the drying section 400 is provided with a drying means such as a hot air supplying means or a heat generating means (not shown in the diagram). The drying section 400 is provided with a discharge port 404, and the planographic printing plate dried by the drying means is discharged through the discharge port 404.

### [Method of Replenishing Developer Replenishing Liquid, and Method of Replenishing Reclaimed Water]

Next, the developer replenishing liquid will be explained.

The "development initiating liquid" according to the present specification means an untreated developer liquid unless particularly stated otherwise, and the "developer replenishing liquid" means a replenishing liquid for development that is replenished into the developer liquid in the developing bath, which has been deteriorated as a result of the development process of the photosensitive planographic printing plate precursor, absorption of carbon dioxide, and the like.

The composition of the developer replenishing liquid is basically the same composition as the composition of the development initiating liquid described above; however, if necessary, the developer replenishing liquid may be highly active compared with the development initiating liquid, in order to restore the activity of the deteriorated developer liquid.

The development initiating liquid that is initially fed into the developing bath of the automatic developing machine 10 is deteriorated by the eluted substance generated by the processing of the photosensitive planographic printing plate precursor. Therefore, in order to perform the development process continuously for a long time in the automatic developing machine 10, it is usually necessary to replenish, intermittently or continuously, at least any one of the developer replenishing liquid or water, which compensates for deterioration, in order to maintain the development quality of the photosensitive planographic printing plate precursor.

Regarding specific replenishing methods, the following four patterns may be conceived: (1) replenishing with a developer liquid having the same concentration as that of the development initiating liquid that is initially introduced; (2) replenishing with a developer liquid having the same concentration as that of the development initiating liquid that is initially introduced, and water in an amount that corresponds to volatilization; (3) replenishing with a developer liquid with a higher concentration, and water; and (4) replenishing with water in an amount that corresponds to volatilization.

In the case of (1), specifically, a concentrated developer liquid is diluted in advance with reclaimed water to obtain a developer liquid having the same concentration as that of the development initiating liquid that is initially introduced, and then this is used for replenishing. In the case of (2) or (3), replenishment of the developer liquid and replenishment of water are carried out independently, and reclaimed water is used for evaporation correction. In the case of (4), replenishment is carried out with reclaimed water only.

### [Other Plate-Making Processes]

Additionally, in the plate-making processes for producing a planographic printing plate from the photosensitive planographic printing plate precursor of the invention, the entire surface may be heated if necessary, before exposure, during exposure, or at any time between exposure and development. Through such heating, the image forming reaction in the image recording layer is accelerated, and there may be merits such as an enhancement of sensitivity or printing durability, or stabilization of sensitivity. Furthermore, for the purpose of increasing the image strength and printing durability, it is also effective to perform post-heating of the entire surface or exposure of the entire surface for the image obtained after development. Usually, heating before development is preferably carried out under mild conditions of 150°C or lower. If the temperature is too high, there is a problem in that non-image areas may be fogged. Very harsh conditions are used for the heating after development. Usually, the temperature is in the range of from 200°C to 500°C. If the temperature is low, a sufficient image reinforcing action is not obtained, and if the temperature is too high, there occur problems such as deterioration of the support, and thermal decomposition of image areas.

### EXAMPLES

Hereinafter, the invention will be described in detail by way of specific examples, but the invention is not intended to be limited to the following descriptions.

### [Example 1]

### 1. Production of photosensitive planographic printing plate precursor 1

### [Production of aluminum support 1]

In order to remove the rolling oil at the surface of an aluminum plate (material: JIS A1050) having a thickness of 0.3 mm, the aluminum plate was subjected to a degreasing treatment for 30 seconds at 50°C using a 10 mass% aqueous solution of sodium aluminate, subsequently the aluminum surface was grained using three bundled nylon brushes having a fiber diameter of 0.3 mm and an aqueous suspension of pumice (specific gravity: 1.1 g/cm³) having a median diameter of 25 µm, and then the aluminum surface was washed thoroughly with water. This plate was etched by immersing the plate in a 25 mass% aqueous solution of sodium hydroxide at 45°C for 9 seconds, washed with water, subsequently further immersed in a 20 mass% aqueous solution of nitric acid at 60°C for 20 seconds, and washed with water. The amount of etching of the grained surface at this time was about 3 g/m².

Next, an electrochemical surface roughening treatment was carried out continuously using an alternating current voltage of 60 Hz. The electrolyte liquid used at this time was a 1 mass% aqueous nitric acid solution (containing 0.5% by mass of aluminum ions) having a liquid temperature of 50°C. Regarding the waveform of the alternating current power supply, a trapezoidal rectangular wave alternating current having a time TP, which was taken by the current value to reach from zero to the peak value, of 0.8 msec and having a duty ratio of 1:1 was used, and the electrochemical surface roughening treatment was carried out using a carbon electrode as a counter electrode. Ferrite was used for an auxiliary anode. The current density was 30 A/dm² as the peak value of current, and 5% of the current flowing from the power supply was distributed to the auxiliary anode. Regarding the amount of electricity used for the nitric acid electrolysis, the amount of electricity when the aluminum plate was the anode was 175 C/dm². Thereafter, the aluminum plate was washed with water by spraying.

Next, an electrochemical surface roughening treatment was carried out using an electrolyte liquid that was a 0.5 mass% aqueous hydrochloric acid solution (containing 0.5% by mass of aluminum ions) having a liquid temperature of 50°C, by the same method as the nitric acid electrolysis, under the conditions that the amount of electricity when the aluminum plate was the anode was 50 C/dm². Thereafter, the aluminum plate was washed with water by spraying. On this aluminum plate, a direct current anodic oxide film of 2.5 g/m² was provided using a 15 mass% aqueous sulfuric acid solution (containing 0.5% by mass of aluminum ions) as an electrolyte liquid under the conditions of a current density of 15 A/dm², and then the aluminum plate was washed with water and dried. Thus, an aluminum support 1 was produced.

The center line average roughness (Ra) of the support obtained in this manner was measured using a needle having a diameter of 2 µm, and the roughness was 0.51 µm.

### [Production of Aluminum Support 2]

The aluminum support 1 was treated with a 1 mass% aqueous solution of sodium silicate for 10 seconds at 20°C, and thus an aluminum support 2 was produced. The surface roughness thereof was measured, and the value was 0.54 µm (Ra expression according to JIS B0601).

### [Formation of Undercoat Layer]

An undercoat layer coating liquid (1) as described below was applied on the aluminum support 2 using a bar coater, and was dried at 80°C for 20 seconds. Thus, a support 3 was produced. The mass of coating of the undercoat layer after drying was 15 mg/m².

### <Undercoat layer coating liquid (1)>

| | |
|---|---|
| Polymer described below (SP3) | 2.7 g |
| Pure water | 900.0 g |
| Methanol | 100.0 g |

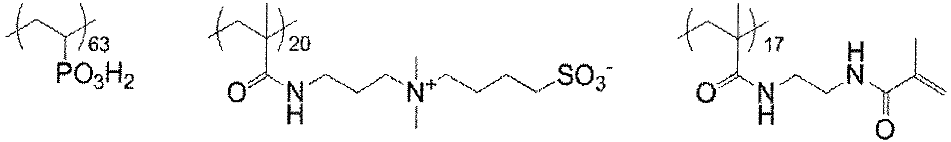

Polymer (SP3) mass average molecular weight: 20,000

### [Formation of Image Recording Layer 1]

An image recording layer coating liquid 1 having a composition as described below was applied by bar coating on the undercoat layer of the support 3, and was dried in an oven at 90°C for 60 seconds. Thus, an image recording layer 1 having a dried amount of coating of 1.3 g/m² was formed.

### <Image Recording Layer Coating Liquid 1>

- Binder polymer (1) described below 0.34 g
   (mass average molecular weight: 80,000)
- Polymerizable compound (1) described below 0.68 g
   (PLEX6661-O, manufactured by Degussa Japan Co., Ltd.)
- Sensitizing colorant (1) described below 0.06 g
- Polymerization initiator (1) described below 0.18 g
- Chain transfer agent (1) described below 0.02 g
- Dispersion of ε-phthalocyanine pigment 0.40 g
(pigment: 15 parts by mass, dispersant (allyl methacrylate/methacrylic acid copolymer (mass average molecular weight: 60,000, copolymerization molar ratio: 83/17)): 10 parts by mass, cyclohexanone: 15 parts by mass)
- Thermal polymerization inhibitor 0.01 g
   (N-nitrosophenylhydroxylamine aluminum salt)
- Fluorine-containing surfactant (1) described below 0.001 g
   (mass average molecular weight: 10,000)
- Polyoxyethylene-polyoxypropylene condensate 0.02 g
   (manufactured by Adeka Corp., PLURONIC L44)
- Dispersion of yellow pigment 0.04 g
(containing yellow pigment: NOVOPERM YELLOW H2G (manufactured by Clariant AG): 15 parts by mass, dispersant (allyl methacrylate/methacrylic acid copolymer (mass average molecular weight: 60,000, copolymerization molar ratio: 83/17)): 10 parts by mass, and 15 parts by mass of cyclohexanone as a solvent)
- 1-Methoxy-2-propanol 3.5 g
- Methyl ethyl ketone 8.0 g

Binder polymer (1) 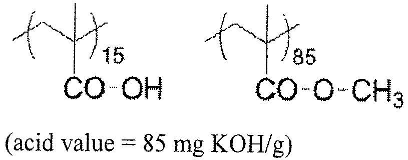
Polymerizable compound (1) 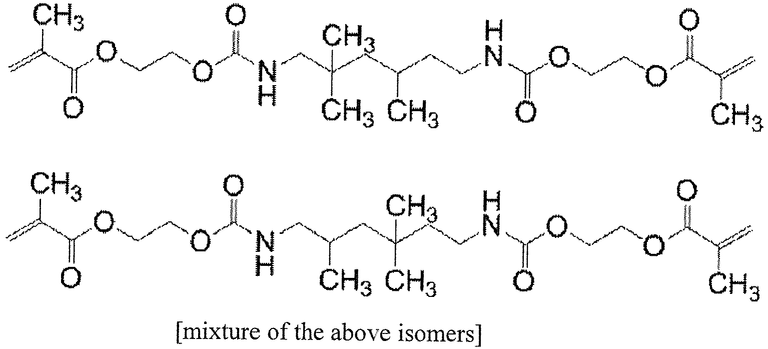
Sensitizing colorant (1) 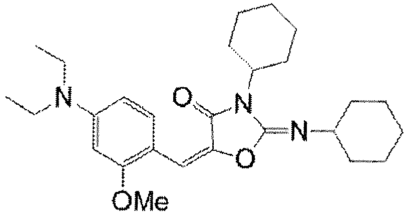
Polymerization initiator (1)

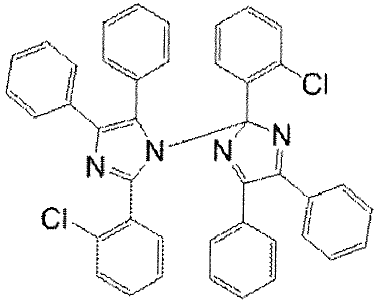

Chain transfer agent (1) 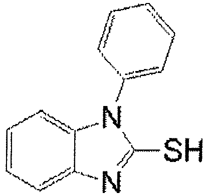
Fluorine-containing surfactant (1)

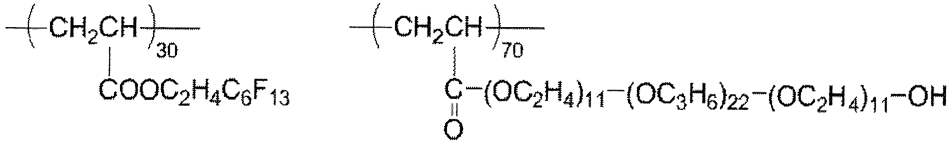

### [Formation of Protective Layer 1]

A protective layer coating liquid 1 having a composition as described below was applied on the image recording layer 1 using a bar such that the dried amount of coating would be 1.5 g/m², and then the coating liquid was dried at 125°C for 70 seconds to form a protective layer. Thus, a photosensitive planographic printing plate precursor 1 was obtained.

### <Protective Layer Coating Liquid 1>

- Mica dispersion liquid (1) 0.6 g
- Sulfonic acid-modified polyvinyl alcohol 0.73 g
(GOHSERAN CKS-50, manufactured by the Nippon Synthetic Chemical Industry Co., Ltd., degree of saponification: 99 mol%, average degree of polymerization: 300, degree of modification: about 0.4 mol%)
- Poly(vinylpyrrolidone/vinyl acetate (1/1)) 0.001 g
   (mass average molecular weight: 70,000)
- Surfactant 0.002 g
   (EMALEX 710, manufactured by Nihon Emulsion Co., Ltd.)
- Water 13 g

### (Production of Mica Dispersion Liquid (1))

32 g of synthetic mica (SOMASIF ME-100, manufactured by Co-Op Chemicals Co., Ltd., aspect ratio: 1000 or more) was added to 368 g of water, and the mixture was dispersed using a homogenizer until the average particle size (laser scattering method) would be 0.5 µm. Thus, a mica dispersion liquid (1) was obtained.

### [Exposure of Photosensitive Planographic Printing Plate Precursor]

The photosensitive planographic printing plate precursor 1 was imagewise exposed using a Violet semiconductor laser plate setter Vx9600 (equipped with an InGaN-based semiconductor laser (emission wavelength: 405 nm±10 nm/power output: 30 mW)) manufactured by Fujifilm Electronic Imaging, Ltd. (FFEI). The imagewise exposure was carried out at a resolution of 2438 dpi using an FM screen (TAFFETA 20) manufactured by Fujifilm Corp., at an amount of plate surface exposure of 0.05 mJ/cm² so as to obtain a halftone area ratio of 50%.

Subsequently, preheating was carried out at 100°C for 30 seconds.

### [Development Processing Step]

The photosensitive planographic printing plate precursor after exposure was subjected to a development process using an automatic development processing machine having a structure illustrated in Fig. 3, and using various developer liquids described below. The automatic development processing machine had a brush roll having an outer diameter of 50 mm and produced by planting polybutylene terephthalate fibers (diameter of fiber: 200 µm, fiber length: 17 mm), and the brush roll was rotated 200 times per minute (circumferential speed of the edge of the brush: 0.52 m/sec) in the same direction as the conveyance direction. The temperature of the developer liquid was 30°C. The conveyance of the photosensitive planographic printing plate precursor was carried out at a conveyance speed of 100 cm/min. After the development process, drying was carried out at the drying section. The drying temperature was 80°C.

### <Developer Liquid 1>

- Sodium carbonate 1.30 g
- Sodium hydrogen carbonate 0.7 g
- Particular nonionic surfactant or particular anionic surfactant
   [compound described in Table 1] Amount described in Table 1 (g)
- Organic solvent Amount described in Table 1 (g)
   [compound described in Table 1]
- Particular betaine-based surfactant Amount described in Table 1 (g)
   [compound described in Table 1]
- SURFINOL DF-110D 0.05 g
- Monobasic ammonium phosphate 0.2 g
- 2-Bromo-2-nitropropane-1,3-diol 0.001 g
- 2-Methyl-4-isothiazolin-3-one 0.001 g
- Trisodium citrate 1.50 g
- Distilled water Added to make up a total amount of 100 g
   (pH: 9.8)

The structures of the surfactants used in the developer liquid will be shown below. Surfactants (R-1) and (R-2) are comparative surfactants that do not have a phenyl group or a naphthyl group.

**Table 1**

| Developer liquid | Particular surfactant | | Organic solvent | | Betaine type surfactant | |
|---|---|---|---|---|---|---|
| | Compound | Content | Compound | Content | [Compound] | [Content] |
| Invented Product 1 | (1) | 5 | None | 0 | (A)+(B) | [1.5+0.3] |
| Invented Product 2 | (2) | 5 | Benzyl alcohol | 1 | - | |
| Invented Product 3 | (1) | 5 | None | 0 | - | |
| Invented Product 4 | (3) | 5 | None | 0 | (A) | [0.5] |
| Invented Product 5 | (4) | 5 | None | 0 | - | |
| Invented Product 6 | (5) | 5 | Benzyl alcohol | 1 | - | |
| Invented Product 7 | (1) | 1 | None | 0 | (A)+(B) | [1.5+03] |
| Invented Product 8 | (1) | 9 | None | 0 | (A)+(B) | [1.5+0.3] |
| Invented Product 9 | (5) | 1 | Benzyl alcohol | 1 | - | |
| Invented Product 10 | (5) | 9 | Benzyl alcohol | 1 | - | |
| Invented Product 11 | (5) | 1 | None | 0 | (B) | [1.0] |
| Invented Product 12 | (1) | 5 | None | 0 | (A)+(B) | [1.5+0.3] |
| Invented Product 13 | (1) | 5 | None | 0 | (A)+(B) | [1.5+0.3] |
| Comparative Product 1 | (R-1) | 5 | None | 0 | (A)+(B) | [1.5+0.3] |
| Comparative Product 2 | (R-2) | 5 | None | 0 | (A)+(B) | [1.5+0.3] |
| Comparative Product 3 | (1) | 0.5 | None | 0 | (A)+(B) | [1.5+0.3] |
| Comparative Product 4 | (1) | 12 | None | 0 | (A)+(B) | [1.5+0.3] |
| Comparative Product 5 | (2) | 5 | Benzyl alcohol | 3 | - | |
| Comparative Product 6 | (5) | 5 | Benzyl alcohol | 3 | - | |
| Comparative Product 7 | (2) | 5 | Ethanol | 1 | - | |
| Comparative Product 8 | (1) | 5 | None | 0 | (A)+(B) | [1.5+0.3] |

Symbol "-" in Table 1 means that the developer liquid does not contain a betaine type surfactant.

Particular surfactants 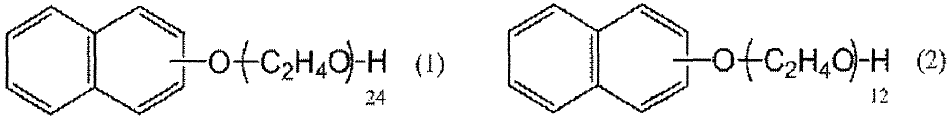 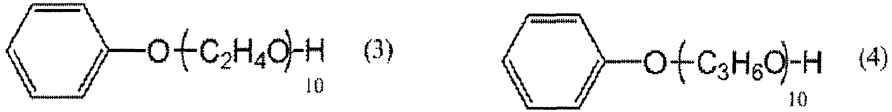 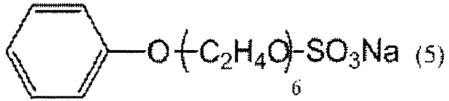
Comparative surfactants 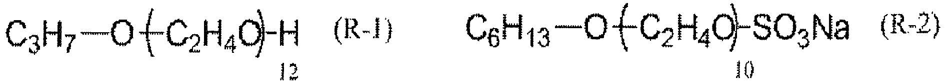
Betaine type surfactants

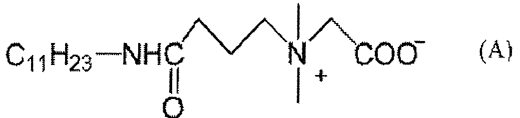

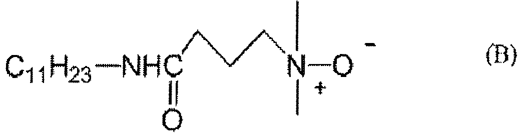

### [Waste Liquid Concentrating Step and Reclaimed Water Producing Step]

100 L of the developer liquid described above was introduced into the automatic developing machine (20 L to the developing bath and 80 L to the external tank), and then 1500 m² of a photosensitive planographic printing plate precursor was subjected to a plate-making process continuously without exchanging or replenishing the developer liquid, and then the development processing liquid was drained. The drained liquid thus obtained was concentrated using a waste liquid concentrating apparatus XR-2000 manufactured by Fujifilm Global Graphic Systems Co., Ltd., so as to obtain a concentration ratio indicated in the following Table 2 (waste liquid concentrating step).

### (Evaluation of Planographic Printing Plate after Plate-Making)

1500 m² of the photosensitive planographic printing plate precursor was continuously subjected to a plate-making process, and then the development state of the planographic printing plate obtained after the plate-making process was visually inspected and evaluated according to the following criteria.
No problem: Favorable development state
Defective development: There was residual image recording layer in the non-image areas due to defective development.
Over-development: Due to over-development, defects such as image deletion occurred in the image areas .
Development residue generation: Residue caused by precipitation of developed components and the like was generated in the developing bath, and adhered to the plate.

### (Evaluation of Concentrated Liquid in Waste Liquid Concentrating Step)

An investigation was made on the foamability and precipitability of waste liquid in the concentrating apparatus on the occasion in which waste liquid was concentrated in the waste liquid concentrating step. For waste liquid which caused precipitation of solid components in the apparatus, and waste liquid which caused foaming, the water vapor separated therefrom was not adequate to be used as reclaimed water and was not supplied to usage.

### (Reclaimed Water Producing Step and Evaluation of Reclaimed Water)

The water vapor evaporatively separated in the waste liquid concentrating apparatus XR-2000 manufactured by Fujifilm Global Graphic Systems Co., Ltd. was condensed, and reclaimed water was obtained.

The presence or absence of any solvent in the reclaimed water thus obtained was checked. Any reclaimed water in which incorporation of a solvent was confirmed was not supplied to usage because the solvent affects the formulation of the developer liquid.

**Table 2**

| Developer liquid | Evaluation of plate-making | Concentration ratio | Evaluation of waste liquid concentrating step/reclaimed water |
|---|---|---|---|
| Invented Product 1 | No problem | 1/4 | No problem |
| Invented Product 2 | No problem | 1/4 | No problem |
| Invented Product 3 | No problem | 1/4 | No problem |
| Invented Product 4 | No problem | 1/4 | No problem |
| Invented Product 5 | No problem | 1/4 | No problem |
| Invented Product 6 | No problem | 1/4 | No problem |
| Invented Product 7 | No problem | 1/4 | No problem |
| Invented Product 8 | No problem | 1/4 | No problem |
| Invented Product 9 | No problem | 1/4 | No problem |
| Invented Product 10 | No problem | 1/4 | No problem |
| Invented Product 11 | No problem | 1/4 | No problem |
| Invented Product 12 | No problem | 1/10 | No problem |
| Invented Product 13 | No problem | 1/2 | No problem |
| Comparative Product 1 | Development residue generation | 1/4 | Precipitation |
| Comparative Product 2 | Development residue generation | 1/4 | Precipitation |
| Comparative Product 3 | Defective development | 1/4 | Precipitation |
| Comparative Product 4 | Over-development | 1/4 | Foaming |
| Comparative Product 5 | Over-development | 1/4 | - |
| Comparative Product 6 | Over-development | 1/4 | - |
| Comparative Product 7 | No problem | 1/4 | Solvent incorporation into reclaimed water |
| Comparative Product 8 | No problem | 1/12 | Precipitation |

Symbol "-" in Table 2 means that no evaluation was made.

### [Reclaimed Water Supplying Step]

Among the reclaimed water obtained after the waste liquid concentrating step and subsequent reclaimed water producing step, any reclaimed water that did not cause any problem in the evaluations described above was used. The reclaimed water was supplied to a replenishing water tank, and a required amount was circulated through the replenishing water tank to the developing bath of the automatic developing machine.

Thereafter, each of the developer liquids of Invented Product 1 to Invented Product 13 was used, and a plate-making process was continuously carried out while the reclaimed water obtained from each of these developer liquids was supplied as replenishing water. In all cases, favorable plate-making was achieved in the continuous plate-making process for 1500 m² of a photosensitive planographic printing plate precursor, and there was no occurrence of any problem.

### [Example 2]

### 2. Production of Photosensitive Planographic Printing Plate Precursor 2

### <Production of Support 4>

An aluminum plate (material: 1050, tempered H16) having a thickness of 0.24 mm was immersed in a 5 mass% aqueous solution of sodium hydroxide maintained at 65°C, and the aluminum plate was subjected to a degreasing treatment for one minute and then washed with water. This aluminum plate was immersed for one minute in a 10 mass% aqueous hydrochloric acid solution maintained at 25°C to be neutralized, and then was washed with water. Subsequently, this aluminum plate was subjected to an electrolytic surface roughening for 60 seconds in a 0.3 mass% aqueous hydrochloric acid solution using an alternating current under the conditions of 25°C and a current density of 100 A/dm², and then the aluminum plate was subjected to a desmutting treatment for 10 seconds in a 5 mass% aqueous solution of sodium hydroxide maintained at 60°C. This aluminum plate was subjected to an anodization treatment for one minute in a 15 mass% aqueous sulfuric acid solution under the conditions of 25°C, a current density of 10 A/dm², and a voltage of 15 V, further immersed in a 1 mass% aqueous solution of polyvinylphosphonic acid at 60°C for 10 seconds, washed with hard water having a calcium ion concentration of 75 ppm at 20°C for 4 seconds, and washed with pure water for 4 seconds, thereby carrying out a hydrophilization treatment, and was dried. Thus, a support 4 was produced. The amount of calcium attached was 2.0 mg/m². The surface roughness of the support 4 was measured, and the value was 0.44 µm (indication of Ra according to JIS B0601).

### <Formation of Image Recording Layer 2>

An image recording layer coating liquid (2) having the composition described below was applied on a support 4 by bar coating, and then the coating liquid was dried in an oven at 90°C for 60 seconds. Thus, an image recording layer 2 having an amount of dried coating of 1.3 g/m² was formed.

### <Image Recording Layer Coating Liquid (2)>

- Binder polymer (1) described below 0.04 g
   (mass average molecular weight: 50,000)
- Binder polymer (2) described below 0.30 g
   (mass average molecular weight: 80,000)
- Polymerizable compound (1) described below 0.17 g
   (PLEX6661-O, manufactured by Degussa Japan Co., Ltd.)
- Polymerizable compound (2) described below 0.51 g
- Sensitizing colorant (1) described below 0.03 g
- Sensitizing colorant (2) described below 0.015 g
- Sensitizing colorant (3) described below 0.015 g
- Polymerization initiator (1) described below 0.13 g
- Chain transfer agent: mercaptobenzothiazole 0.01 g
- Dispersion of ε-phthalocyanine pigment 0.40 g
(pigment: 15 parts by mass, dispersant (allyl methacrylate/methacrylic acid copolymer (mass average molecular weight: 60,000, copolymerization molar ratio: 83/17)): 10 parts by mass, cyclohexanone: 15 parts by mass)
- Thermal polymerization inhibitor 0.01 g
   N-nitrosophenylhydroxylamine aluminum salt
- Fluorine-containing surfactant (1) described below 0.001 g
   (mass average molecular weight: 10,000)
- 1-Methoxy-2-propanol 3.5 g
- Methyl ethyl ketone 8.0 g
- N,N-dimethylaminopropyl methacrylamide 0.015 g

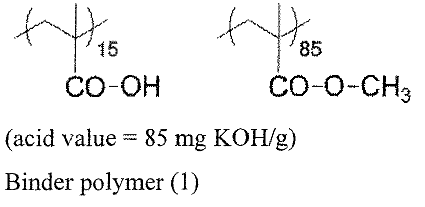

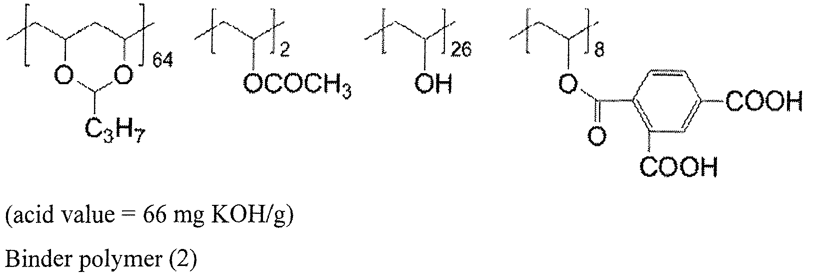

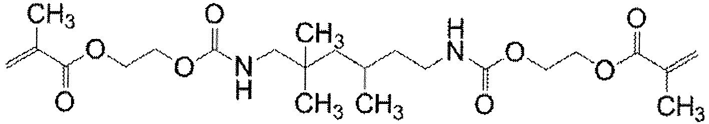

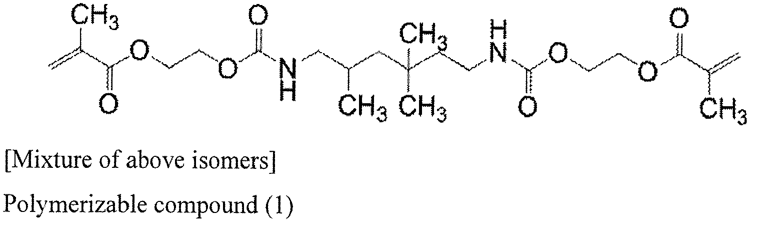

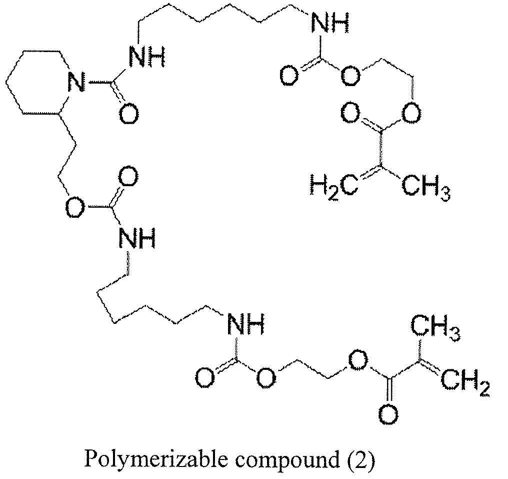

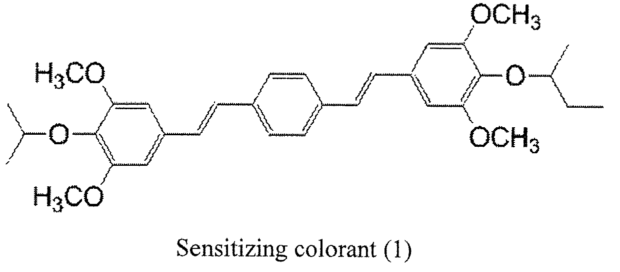

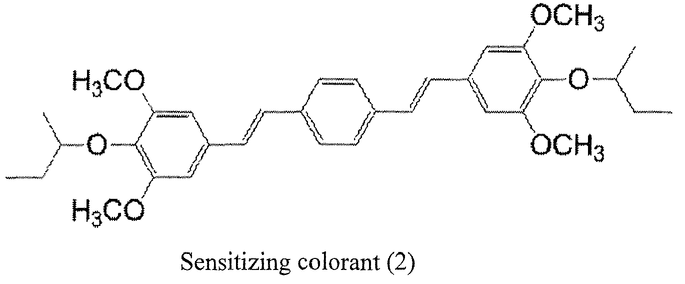

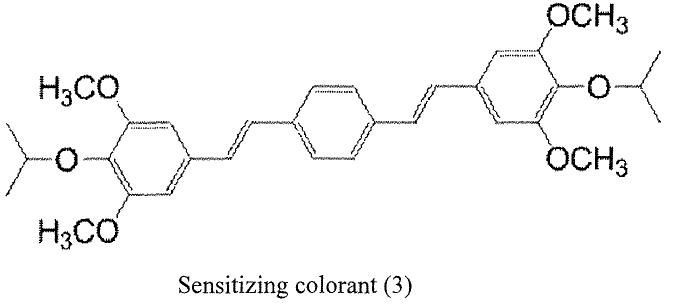

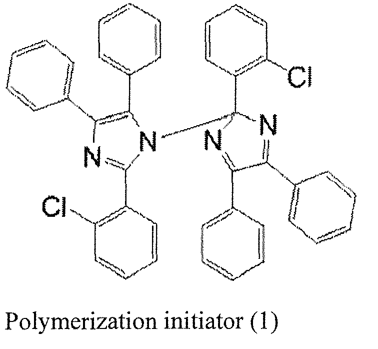

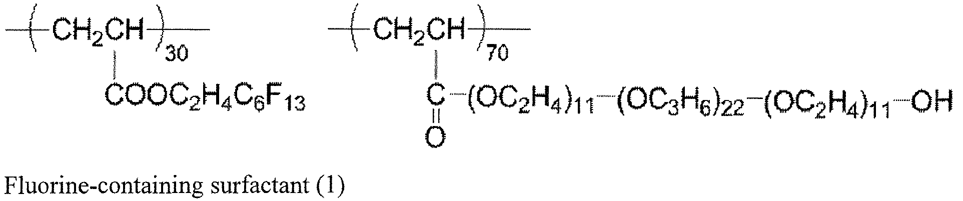

### [Formation of Protective Layer 2]

A protective layer coating liquid 2 having the following composition was applied on the image recording layer 2 by bar coating such that the amount of dried coating would be 1.2 g/m², and then the coating liquid was dried at 125°C for 70 seconds to form a protective layer 2. Thus, a photosensitive planographic printing plate precursor 2 was obtained.

### <Protective Layer Coating Liquid 2>

- Polyvinyl alcohol 40 g
   (degree of saponification: 98 mol%, degree of polymerization: 500)
- Polyvinylpyrrolidone (molecular weight: 50,000) 5 g
- Poly[vinylpyrrolidone/vinyl acetate (1/1)] 0.5 g
   (molecular weight: 70,000)
- Surfactant 0.5 g
   (EMALEX 710, manufactured by Nihon Emulsion Co., Ltd.)
- Water 950 g

### <Developer Liquid 2>

- Particular nonionic surfactant or particular anionic surfactant
   [compound described in Table 3] Amount described in Table 3 (g)
- Organic solvent Amount described in Table 3 (g)
   [compound described in Table 3]
- Triethanolamine 0.5 g
- Sodium gluconate 1.0 g
- Trisodium citrate 0.5 g
- Tetrasodium ethylenediaminetetraacetate 0.05 g
- Polystyrenesulfonic acid 1.0 g
   (VERSA TL77 (30 mass% solution), manufactured by Alco Chemical, Inc.) (adjusted to obtain the pH of Table 4 by adding phosphoric acid)
- Water Added to make up a total amount of 100 g

The structures of the various surfactants and solvent (S) used in the developer liquid are shown below. Surfactant (R-3) is a comparative surfactant that does not have a phenyl group or naphthyl group.

### [Development Processing Step]

A photosensitive planographic printing plate precursor after exposure was subjected to a development process using an automatic development processing machine having a structure illustrated in Fig. 3, and using the various developer liquids described in the following Table 3. The automatic development processing machine had a brush roll having an outer diameter of 50 mm and produced by planting polybutylene terephthalate fibers (diameter of fiber: 200 µm, fiber length: 17 mm), and the brush roll was rotated 200 times per minute (circumferential speed of the edge of the brush: 0.52 m/sec) in the same direction as the conveyance direction. The temperature of the developer liquid was 30°C. The conveyance of the photosensitive planographic printing plate precursor was carried out at a conveyance speed of 100 cm/min. After the development process, drying was carried out at the drying section. The drying temperature was 80°C.

**Table 3**

| Developer liquid | Particular surfactant or comparative surfactant | | Organic solvent | |
|---|---|---|---|---|
| | Compound | Content | Compound | Content |
| Invented Product 14 | (6) | 5 | Organic solvent (S) | 1 |
| Invented Product 15 | (6) | 5 | None | 0 |
| Invented Product 16 | (7) | 5 | Organic solvent (S) | 1 |
| Invented Product 17 | (2) | 5 | Organic solvent (S) | 1 |
| Invented Product 18 | (2) | 5 | Organic solvent (S) | 1 |
| Invented Product 19 | (6) | 1 | Organic solvent (S) | 1 |
| Invented Product 20 | (6) | 10 | Organic solvent (S) | 1 |
| Invented Product 21 | (6) | 10 | Organic solvent (S) | 1 |
| Invented Product 22 | (6) | 10 | Organic solvent (S) | 1 |
| Comparative Product 9 | (R-3) | 5 | Organic solvent (S) | 1 |
| Comparative Product 10 | (6) | 0.5 | Organic solvent (S) | 1 |
| Comparative Product 11 | (6) | 12 | Organic solvent (S) | 1 |
| Comparative Product 12 | (6) | 5 | Ethanol | 3 |
| Comparative Product 13 | (6) | 5 | Organic solvent (S) | 3 |
| Comparative Product 14 | (6) | 5 | Organic solvent (S) | 1 |

Particular surfactant 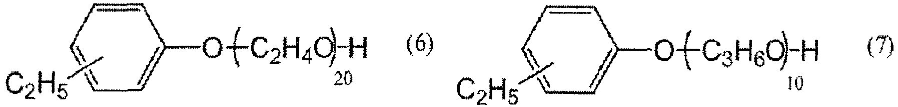
Comparative surfactant 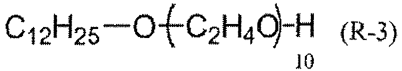
Organic solvent

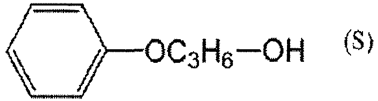

### [Waste Liquid Concentrating Step and Reclaimed Water Producing Step]

A continuous plate-making process of a photosensitive planographic printing plate precursor, a waste liquid concentrating step, and a reclaimed water producing step were carried out in the same manner as in Example 1, except that the developer liquids of Invented Products 14 to 22 and Comparative Products 9 to 14 described in the above Table 3 were used instead of Invented Product 1 as the developer liquid, and the photosensitive planographic printing plate precursor 2 was used instead of the photosensitive planographic printing plate precursor 1. The results obtained by performing evaluations in the same manner are presented in the following Table 4.

**Table 4**

| Developer liquid | pH of developer liquid | Evaluation of plate-making | Concentration ratio | Evaluation of waste liquid concentrating step/reclaimed water |
|---|---|---|---|---|
| Invented Product 14 | 7 | No problem | 1/4 | No problem |
| Invented Product 15 | 7 | No problem | 1/4 | No problem |
| Invented Product 16 | 7 | No problem | 1/4 | No problem |
| Invented Product 17 | 7 | No problem | 1/4 | No problem |
| Invented Product 18 | 9.8 | No problem | 1/4 | No problem |
| Invented Product 19 | 7 | No problem | 1/10 | No problem |
| Invented Product 20 | 7 | No problem | 1/4 | No problem |
| Invented Product 21 | 6 | No problem | 1/4 | No problem |
| Invented Product 22 | 5 | No problem | 1/4 | No problem |
| Comparative Product 9 | 7 | Development residue generation | 1/4 | Precipitation |
| Comparative Product 10 | 7 | Defective development | 1/4 | Precipitation |
| Comparative Product 11 | 7 | Over-development | 1/4 | Foaming |
| Comparative Product 12 | 7 | No problem | 1/4 | Solvent incorporation into reclaimed water |
| Comparative Product 13 | 7 | Over-development | 1/4 | - |
| Comparative Product 14 | 7 | No problem | 1/12 | Precipitation |

Symbol "-" in Table 4 means that no evaluation was made.

### [Reclaimed Water Supplying Step]

In the embodiment described above as well, when the Invented Products 14 to 22 were used as developer liquids, a plate-making process was further carried out continuously by supplying reclaimed water in the same manner as in the case of Invented Product 1. It was confirmed that favorable plate-making was achieved.

As is clearly shown in Table 2 and Table 4, it is understood that according to the method of concentrating plate-making process waste liquid of the invention, a development process and a desensitization process can be carried out simultaneously in a single developing bath, and reclaimed water appropriate for recycling is produced. On the other hand, when a developer liquid that was not in the scope of the invention was used, there occurred problems such as incorporation of a solvent into reclaimed water, and precipitation of solid components during the concentrating step. Thus, a reduction of waste liquid and production of reclaimed water could not be carried out favorably.

## Claims

1. A method of concentrating waste liquid from a plate-making process of a planographic printing plate, the method comprising:
a plate-making processing step of subjecting a negative-type photosensitive planographic printing plate precursor, having a radical polymerizable image recording layer on a support, after exposure simultaneously to a development process and a desensitization process using a developer liquid in a single development processing bath of an automatic developing machine that develops the negative-type photosensitive planographic printing plate precursor after exposure,
wherein the developer liquid contains from 1% by mass to 10% by mass, based on the total amount of the developer liquid, of a surfactant having a phenyl group or a naphthyl group and at least either an ethylene oxide group or a propylene oxide group,
and has a content of an organic solvent having a boiling point in a range of from 100°C to 300°C of 2% by mass or less, based on the total amount of the developer liquid, and
substantially does not contain an organic solvent having a boiling point lower than 100°C or higher than 300°C;
a waste liquid concentrating step of evaporatively concentrating plate-making process waste liquid produced by the plate-making processing step using a waste liquid concentrating apparatus such that a ratio of a volume of the plate-making process waste liquid after concentration to a volume of the plate-making process waste liquid before concentration is from 1/2 to 1/10; and
a reclaimed water producing step of producing reclaimed water by condensing water vapor separated in the waste liquid concentrating step,
wherein a pH of the developer liquid is from 6 to 10, wherein a developer liquid is excluded which includes a surfactant and a hydroxide of an alkali metal but does not include a silicate compound, and which has a pH of 10.

2. A method of recycling waste liquid from a plate-making process of a planographic printing plate, the method comprising, after the steps as defined in claim 1:
a reclaimed water supplying step of supplying the reclaimed water obtained in the reclaimed water producing step to the automatic developing machine.

3. The method according to claim 2, wherein in the surfactant the number of the ethylene oxide groups or the propylene oxide groups is from 5 to 30.

4. The method according to claim 2 or 3, wherein the developer liquid further contains at least one compound represented by the following Formula <1>, Formula <2>, or Formula <3>, and a total content of the compounds represented by the following Formula <1>, Formula <2>, and Formula <3> in the developer liquid is less than 10% by mass: 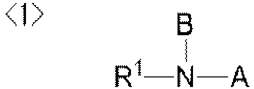 wherein, in Formula <1>, R¹ represents a hydrogen atom, an alkyl group, or a substituent having the following structure: 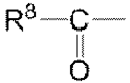 wherein R⁸ represents a hydrogen atom or an alkyl group; and
A represents a hydrogen atom, an alkyl group, a monovalent substituent containing an ethylene oxide group, a monovalent substituent containing a carboxylic acid group, or a monovalent substituent containing a carboxylic acid salt; and B represents a monovalent substituent containing an ethylene oxide group, a monovalent substituent containing a carboxylic acid group, or a monovalent substituent containing a carboxylic acid salt; 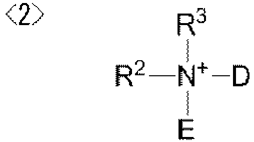 wherein, in Formula <2>, each of R² and R³ independently represents a hydrogen atom, or an alkyl group which may have a substituent, but at least one of R² or R³ represents an alkyl group which may have a substituent; D represents an alkyl group, or a monovalent substituent containing an ethylene oxide group; and E represents a monovalent substituent containing a carboxylate anion, or a monovalent substituent containing an oxide anion (O⁻); and 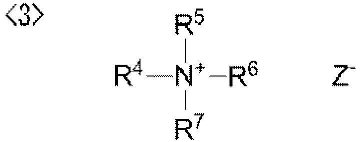 wherein, in Formula <3>, each of R⁴, R⁵, R⁶, and R⁷ independently represents a hydrogen atom or an alkyl group; and Z⁻ represents a counter anion.

5. The method according to any one of claims 2 to 4, further comprising drying a planographic printing plate obtained by subjecting the negative-type photosensitive planographic printing plate precursor after exposure to the development process and the desensitization process.

6. The method according to any one of claims 2 to 4, further comprising: heating the negative-type photosensitive planographic printing plate precursor after exposure, before performing the development process and the desensitization process; and drying a planographic printing plate obtained by subjecting the negative-type photosensitive planographic printing plate precursor after exposure to the development process and the desensitization process.

7. The method according to any one of claims 2 to 6, wherein the waste liquid concentrating apparatus includes a heating means.

8. The method according to claim 7, wherein heating is carried out by the heating means included in the waste liquid concentrating apparatus under reduced pressure.

9. The method according to claim 7 or 8, wherein the heating means included in the waste liquid concentrating apparatus is a heat pump including a heat releasing unit and a heat absorbing unit, and the plate-making process waste liquid is heated by the heat releasing unit of the heat pump, while the water vapor is cooled by the heat absorbing unit of the heat pump.

10. The method according to any one of claims 2 to 9, wherein the waste liquid concentrating step comprises a concentrate collecting step of collecting a concentrate of the plate-making process waste liquid, which has been concentrated by evaporative concentration, into a collecting tank by applying pressure to the concentrate using a pump.

## Patentansprüche

1. Verfahren zum Konzentrieren von Abfallflüssigkeit von einem Plattenerzeugungsverfahren einer Flachdruckplatte, wobei das Verfahren enthält:
einen Plattenerzeugungs-Verarbeitungsschritt zum gleichzeitigen Durchführen eines Entwicklungsverfahrens und eines Desensibilisierungsverfahrens bei einem lichtempfindlichen Flachdruckplattenvorläufer vom Negativtyp, bei dem eine radikalisch polymerisierbare Bildaufzeichnungsschicht auf einem Träger vorliegt, nach Belichtung unter Verwendung einer Entwicklerflüssigkeit in einem einzelnen Entwicklungsverarbeitungsbad einer automatischen Entwicklungsmaschine, die den lichtempfindlichen Flachdruckplattenvorläufer vom Negativtyp nach Belichtung entwickelt,
worin die Entwicklerflüssigkeit von 1 bis 10 Masse-%, bezogen auf die Gesamtmenge der Entwicklerflüssigkeit, eines Tensides mit einer Phenylgruppe oder einer Naphthylgruppe und zumindest einer Ethylenoxidgruppe oder einer Propylenoxidgruppe enthält,
und einen Gehalt eines organischen Lösungsmittels mit einem Siedepunkt in einem Bereich von 100 bis 300°C von 2 Masse-% oder weniger hat, bezogen auf die Gesamtmenge der Entwicklerflüssigkeit, und
im Wesentlichen kein organisches Lösungsmittel mit einem Siedepunkt von weniger als 100°C oder mehr als 300°C aufweist,
einen Abfallflüssigkeits-Konzentrationsschritt zum verdampfenden Konzentrieren der Plattenerzeugungsverfahren-Abfallflüssigkeit, erzeugt durch den Plattenerzeugungsverarbeitungsschritt unter Verwendung einer Abfallflüssigkeit-Konzentrationsanlage, so dass ein Verhältnis eines Volumen der Plattenerzeugungsverfahren-Abfallflüssigkeit nach Konzentration zu einem Volumen der Plattenerzeugungsverfahren-Abfallflüssigkeit vor der Konzentration von 1/2 bis 1/10 ist, und
einen Wiedergewinnungswasser-Erzeugungsschritt zum Erzeugen von wiedergewonnenem Wasser durch Kondensieren von Wasserdampf, der in dem Abfallflüssigkeit-Konzentrationsschritt getrennt ist,
worin ein pH der Entwicklerflüssigkeit von 6 bis 10 ist, worin eine Entwicklerflüssigkeit ausgeschlossen ist, die ein Tensid und ein Hydroxid eines Alkalimetalls enthält, aber keine Silikatverbindung enthält und die einen pH von 10 hat.

2. Verfahren zum Recyceln von Abfallflüssigkeit von einem Plattenerzeugungsverfahren einer Flachdruckplatte, wobei das Verfahren nach den Schritten gemäß Anspruch 1 enthält:
einen Zuführschritt für wiedergewonnenes Wasser zum Zuführen des wiedergewonnenen Wassers, erhalten in dem Erzeugungsschritt für wiedergewonnenes Wasser, zu der automatischen Entwicklungsmaschine.

3. Verfahren gemäß Anspruch 2, worin in dem Tensid die Zahl der Ethylenoxidgruppen oder Propylenoxidgruppen von 5 bis 30 ist.

4. Verfahren gemäß Anspruch 2 oder 3, worin die Entwicklerflüssigkeit weiterhin zumindest eine Verbindung enthält, dargestellt durch die folgende Formel (1), Formel (2) oder Formel (3), und ein Gesamtgehalt der Verbindungen, dargestellt durch die folgenden Formeln (1), (2) und (3) in der Entwicklerflüssigkeit weniger als 20 Masse-% ist: 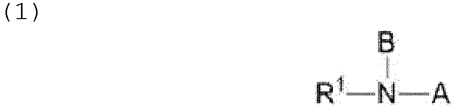 worin in der Formel (1) R¹ ein Wasserstoffatom, eine Alkylgruppe oder ein Substituent mit der folgenden Struktur ist: 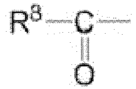 worin R⁸ ein Wasserstoffatom oder eine Alkylgruppe ist und
A ein Wasserstoffatom, Alkylgruppe, monovalenter Substituent mit einer Ethylenoxidgruppe, monovalenter Substituent mit einer Carbonsäuregruppe oder monovalenter Substituent mit einem Carbonsäuresalz ist, und B ein monovalenter Substituent mit einer Ethylenoxidgruppe, monovalenter Substituent mit einer Carbonsäuregruppe oder monovalenter Substituent mit einem Carbonsäuresalz ist, 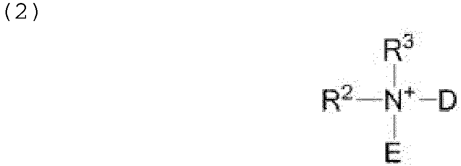 worin in der Formel (2) R² und R³ jeweils unabhängig ein Wasserstoffatom oder eine Alkylgruppe sind, die einen Substituenten haben kann, aber zumindest eines von R² oder R³ eine Alkylgruppe ist, die einen Substituenten haben kann, D eine Alkylgruppe oder ein monovalenter Substituent mit einer Ethylenoxidgruppe ist und E ein monovalenter Substituent mit einem Carboxylatanion oder ein monovalenter Substituent mit einem Oxidanion (O⁻) ist, und 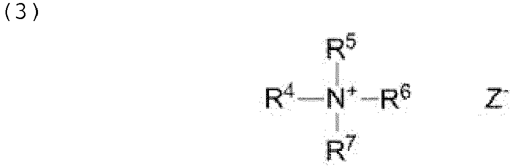 worin in der Formel (3) R⁴, R⁵, R⁶ und R⁷ jeweils unabhängig ein Wasserstoffatom oder eine Alkylgruppe sind und Z⁻ ein Gegenanion ist.

5. Verfahren gemäß einem der Ansprüche 2 bis 4, weiterhin enthaltend das Trocknen einer Flachdruckplatte, erhalten durch Durchführen des Entwicklungsverfahrens und des Desensibilisierungsverfahrens in dem lichtempfindlichen Flachdruckplattenvorläufer vom Negativtyp nach Belichtung.

6. Verfahren gemäß einem der Ansprüche 2 bis 4, weiterhin enthaltend: Erwärmen des lichtempfindlichen Flachdruckplattenvorläufers vom Negativtyp nach Belichtung, vor der Durchführung des Entwicklungsverfahrens und des Desensibilisierungsverfahrens und Trocknen einer Flachdruckplatte, erhalten durch Durchführen des Entwicklungsverfahrens und des Desensibilisierungsverfahrens mit dem lichtempfindlichen Flachdruckplattenvorläufer vom Negativtyp nach Entwicklung.

7. Verfahren gemäß einem der Ansprüche 2 bis 6, worin die Abfallflüssigkeit-Konzentrationsanlage eine Erwärmungsvorrichtung enthält.

8. Verfahren gemäß Anspruch 7, worin das Erwärmen durchgeführt wird durch Erwärmungsmittel unter Druck, die in der Abfallflüssigkeit-Konzentrationsanlage enthalten sind.

9. Verfahren gemäß Anspruch 7 oder 8, worin das Erwärmungsmittel, das in der Abfallflüssigkeit-Konzentrationsanlage enthalten ist, eine Wärmepumpe ist, die zumindest eine Wärmefreisetzungseinheit und eine Wärmeabsorptionseinheit enthält und die Plattenerzeugungsverfahren-Abfallflüssigkeit erwärmt wird durch die Wärmefreisetzungseinheit der Wärmepumpe, während der Wasserdampf durch die Wärmeabsorptionseinheit der Wärmepumpe gekühlt wird.

10. Verfahren gemäß einem der Ansprüche 2 bis 9, worin der Abfallflüssigkeit-Konzentrationsschritt ein Konzentrationssammelschritt zum Sammeln eines Konzentrates der Plattenerzeugungsverfahren-Abfallflüssigkeit, die durch verdampfende Konzentration konzentriert ist, in einen Sammeltank durch Auferlegung von Druck auf das Konzentrat unter Verwendung einer Pumpe enthält.

## Revendications

1. Procédé de concentration d'effluent liquide provenant d'un traitement de fabrication de plaques d'une plaque d'impression planographique, le procédé comprenant :
une étape de traitement de fabrication de plaques consistant à soumettre un précurseur de plaque d'impression planographique photosensible de type négatif, ayant une couche d'enregistrement d'image polymérisable radicale sur un support, après exposition simultanée à un traitement de développement et un traitement de désensibilisation au moyen d'un liquide de développement dans un seul bain de traitement de développement d'une machine de développement automatique qui développe le précurseur de plaque d'impression planographique photosensible de type négatif après exposition,
dans lequel le révélateur liquide contient de 1 % en masse à 10 % en masse, sur la base de la quantité totale du révélateur liquide, d'un tensioactif ayant un groupe phényle ou un groupe naphthyle et au moins l'un ou l'autre d'un groupe oxyde d'éthylène ou d'un groupe oxyde de propylène,
et a une teneur en un solvant organique ayant un point d'ébullition dans une plage de 100 °C à 300 °C de 2 % en masse ou moins, sur la base de la quantité totale du révélateur liquide, et
ne contient sensiblement pas de solvant organique ayant un point d'ébullition inférieur à 100 °C ou supérieur à 300 °C ;
une étape de concentration d'effluent liquide consistant à concentrer par évaporation l'effluent liquide de traitement de fabrication de plaques produit par l'étape de traitement de fabrication de plaques au moyen d'un appareil de concentration d'effluent liquide de telle sorte qu'un rapport d'un volume de l'effluent liquide de traitement de fabrication de plaques après concentration sur un volume de l'effluent liquide de traitement de fabrication de plaques avant concentration est de 1/2 à 1/10 ; et
une étape de production d'eau recyclée consistant à produire de l'eau recyclée en condensant la vapeur d'eau séparée dans l'étape de concentration d'effluent liquide,
dans lequel un pH du révélateur liquide est de 6 à 10, dans lequel est exclu un révélateur liquide qui inclut un tensioactif et un hydroxyde d'un métal alcalin mais n'inclut pas un composé de silicate, et qui a un pH de 10.

2. Procédé de recyclage d'effluent liquide provenant d'un traitement de fabrication de plaques d'une plaque d'impression planographique, le procédé comprenant, après les étapes telles que définies dans la revendication 1 :
une étape de fourniture d'eau recyclée consistant à fournir l'eau recyclée obtenue dans l'étape de production d'eau recyclée à la machine de développement automatique.

3. Procédé selon la revendication 2, dans lequel dans le tensioactif, le nombre des groupes d'oxyde d'éthylène ou des groupes d'oxyde de propylène est de 5 à 30.

4. Procédé selon la revendication 2 ou 3, dans lequel le révélateur liquide contient en outre au moins un composé représenté par la formule <1>, la formule <2> ou la formule <3> suivante, et une teneur totale des composés représentés par la formule <1>, la formule <2> et la formule <3> dans le révélateur liquide est inférieure à 10 % en masse ; 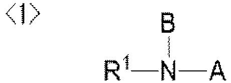 où, dans la formule <1>, R¹ représente un atome d'hydrogène, un groupe alkyle ou un substituant ayant la structure suivante : 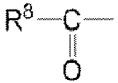 dans lequel R⁸ représente un atome d'hydrogène ou un groupe alkyle ; et
A représente un atome d'hydrogène, un groupe alkyle, un substituant monovalent contenant un groupe oxyde d'éthylène, un substituant monovalent contenant un groupe acide carboxylique, ou un substituant monovalent contenant un sel d'acide carboxylique ; et B représente un substituant monovalent contenant un groupe oxyde d'éthylène, un substituant monovalent contenant un groupe acide carboxylique, ou un substituant monovalent contenant un sel d'acide carboxylique ; 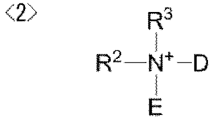 dans lequel, dans la formule <2>, chacun de R² et R³ représente indépendamment un atome d'hydrogène, ou un groupe alkyle qui peut avoir un substituant, mais au moins un de R² ou R³ représente un groupe alkyle qui peut avoir un substituant, D représente un groupe alkyle, ou un substituant monovalent contenant un groupe oxyde d'éthylène, et E représente un substituant monovalent contenant un anion de carboxylate, ou un substituant monovalent contenant un anion d'oxyde (O⁻) ; et 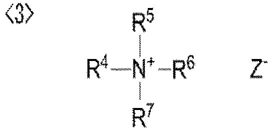 dans lequel, dans la formule <3>, chacun de R⁴, R⁵, R⁶ et R⁷ représente indépendamment un atome d'hydrogène ou un groupe alkyle, et Z⁻ représente un contre-anion.

5. Procédé selon l'une quelconque des revendications 2 à 4, comprenant en outre le séchage d'une plaque d'impression planographique obtenue en soumettant un précurseur de plaque d'impression planographique photosensible de type négatif après exposition au traitement de développement et au traitement de désensibilisation.

6. Procédé selon l'une quelconque des revendications 2 à 4, comprenant en outre le chauffage du précurseur de plaque d'impression planographique photosensible de type négatif après exposition, avant réalisation du traitement de développement et du traitement de désensibilisation ; et le séchage d'une plaque d'impression planographique obtenue par soumission du précurseur de plaque d'impression planographique photosensible de type négatif après exposition au processus de développement et au processus de désensibilisation.

7. Procédé selon l'une quelconque des revendications 2 à 6, dans lequel l'appareil de concentration d'effluent liquide inclut un moyen de chauffage.

8. Procédé selon la revendication 7, dans lequel le chauffage est effectué par les moyens de chauffage inclus dans l'appareil de concentration d'effluent liquide sous pression réduite.

9. Procédé selon la revendication 7 ou 8, dans lequel le moyen de chauffage inclus dans l'appareil de concentration d'effluent liquide est une pompe à chaleur incluant une unité de libération de chaleur et une unité d'absorption de chaleur, et l'effluent liquide de traitement de fabrication de plaques est chauffé par l'unité de libération de chaleur de la pompe à chaleur, alors que la vapeur d'eau est refroidie par l'unité d'absorption de chaleur de la pompe à chaleur.

10. Procédé selon l'une quelconque des revendications 2 à 9, dans lequel l'étape de concentration d'effluent liquide comprend une étape de collecte de concentré consistant à collecter un concentré d'effluent liquide de traitement de fabrication de plaques, qui a été concentré par concentration par évaporation, dans un réservoir de collecte par application de pression sur le concentré au moyen d'une pompe.
